# EUROPEAN PATENT APPLICATION

(11) **EP 4 557 367 A1**
(43) Date of publication of application: **21.05.2025**
(21) Application number: 24821729.1
(22) Date of filing: 24.07.2024
(51) Int. Cl.: H01L 25/065, H01L 23/538

(54) **INTEGRATED CIRCUIT INCLUDING VERTICAL ELECTRICAL CONNECTION CONNECTING PLURALITY OF SEMICONDUCTOR DIES, AND ELECTRONIC DEVICE INCLUDING SAME**

(30) Priority: 27.09.2023 KR 20230131212
(71) Applicant: Samsung Electronics Co., Ltd., Gyeonggi-do 16677 (KR)
(72) Inventor: KIM, Shinho, Suwon-si Gyeonggi-do 16677 (KR); KIM, Mooyoung, Suwon-si Gyeonggi-do 16677 (KR)
(74) Representative: HGF
(86) International application number: PCT/KR2024/010742
(87) International publication number: WO 2025/070982

(57) **Abstract**

According to an embodiment, a processing chip component includes a first die including first circuitry, second circuitry, and first SERDES circuitry connected to the first circuitry and the second circuitry, a second die including third circuitry, fourth circuitry and second SERDES circuitry connected to the third circuitry and the fourth circuitry, and an interconnect layer disposed between the first die and the second die. The interconnect layer includes a first through silicon via (TSV) configured to be connected between the first SERDES circuitry and the second SERDES circuitry and to provide a first signal path between the first circuitry and the third circuitry, a second signal path between the first circuitry and the fourth circuitry, a third signal path between the second circuitry and the third circuitry, and a fourth signal path between the second circuitry and the fourth circuitry.

## Description

### [Technical Field]

The present disclosure relates to an integrated circuit including a vertical electrical connection connecting a plurality of semiconductor dies and an electronic device including the same.

### [Background Art]

System on a chip (SOC) is an electronic component in which circuitry that perform different functions are integrated. In case that the number of functions supported by an electronic device including the SOC increases, complexity of circuitry integrated in the SOC may increase.

The above-described information may be provided as a related art for the purpose of helping understand the present disclosure. None of the above-described content is claimed as a prior art related to the present disclosure, or may be used in decisions related to the prior art.

### [Disclosure]

### [Technical Solution]

According to an embodiment, a processing chip component may comprise a first die including first circuitry, second circuitry, and first serializer-deserializer (SERDES) circuitry connected to the first circuitry and the second circuitry. The processing chip component may comprise a second die including third circuitry, fourth circuitry and second SERDES circuitry connected to the third circuitry and the fourth circuitry. The processing chip component may comprise an interconnect layer disposed between the first die and the second die. The interconnect layer may include a first through silicon via (TSV) configured to be connected between the first SERDES circuitry and the second SERDES circuitry and to provide a first signal path between the first circuitry and the third circuitry, a second signal path between the first circuitry and the fourth circuitry, a third signal path between the second circuitry and the third circuitry, and a fourth signal path between the second circuitry and the fourth circuitry.

According to an embodiment, a processing chip component may comprise a first die including first circuitry and second circuitry, and first SERDES circuitry connected to the first circuitry and the second circuitry. The processing chip component may comprise a second die including third circuitry and fourth circuitry, and second SERDES circuitry connected to the third circuitry and the fourth circuitry. The processing chip component may comprise an interconnect layer disposed between the first die and the second die. The interconnect layer may comprise a first through silicon via (TSV) configured to directly connect the first circuitry to the third circuitry and configured to transmit a signal in a first type to the third circuitry from the first circuitry. The interconnect layer may comprise a second TSV configured to connect the first SERDES circuitry to the second SERDES circuitry and configured to transmit a signal in a second type based on serialization of the first SERDES circuitry. The signal in the second type transmitted through the second TSV may comprise a sequence of at least one bit provided by the first circuitry and at least one bit provided by the second circuitry.

According to an embodiment, an electronic device may comprise a memory and a processor. The processor may comprise a first die comprising a plurality of circuitry including a central processing unit (CPU) and a first serializer-deserializer (SERDES) circuitry coupled to each of the plurality of circuitry. The processor may comprise a second die comprising a memory interface circuitry to communicate with the memory and second SERDES circuitry. The processor may comprise an interconnect layer disposed between the first die and the second die. The interconnect layer may comprise a first through silicon via (TSV) configured to directly connect the CPU of the first die to the memory interface circuitry. The interconnect layer may comprise a second TSV configured to connect the first SERDES circuitry to the second SERDES circuitry. The CPU may be configured to transmit a data signal including data to be stored in the memory to the memory interface circuitry through the first TSV. The CPU may be configured to transmit a control signal for controlling the memory interface circuitry to the first SERDES circuitry such that the data is transmitted to the memory.

According to an embodiment, a three-dimension integrated circuit may comprise a substrate, a first integrated circuit layer disposed over the substrate and comprising a plurality of first circuit elements, a second integrated circuit layer disposed over the first integrated circuit layer and comprising a plurality of second circuit elements, and an interconnect layer disposed between the first integrated circuit layer and the second integrated circuit layer and comprising a plurality of through silicon vias (TSVs). The plurality of first circuit elements may include a plurality of first control signal pins and at least one first data signal terminal. The plurality of first control signal pins may be connected to a first TSV among the plurality of TSVs through a first serializer-deserializer (SERDES) circuit. The plurality of second circuit elements may include a plurality of second control signal pins corresponding to the plurality of first control signal pins and at least one second data signal pin corresponding to at least one first data signal pin. The first TSV may be connected to the plurality of second control signal pins through a second SERDES circuit.

According to an embodiment, an electronic device may comprise a display, an antenna, a printed circuit board, a first integrated circuit disposed on the printed circuit board, and a second integrated circuit disposed on the printed circuit board and electrically connected to the first integrated circuit. The second integrated circuit may comprise a first circuit layer comprising a plurality of first circuit elements, a second circuit layer disposed over the first circuit layer and comprising a plurality of second circuit elements, and a connection layer disposed between the first circuit layer and the second circuit layer and comprising a plurality of through silicon vias (TSVs). The plurality of first circuit elements may include a plurality of first control signal pins and at least one first data signal pin. The plurality of first control signal pins may be connected to the first TSV among the plurality of TSVs through a first serializer-deserializer (SERDES) circuit. The plurality of second circuit elements may include a plurality of second control signal pins corresponding to the plurality of first control signal pins and at least one second data signal pin corresponding to the at least one first data signal pin. The first TSV may be connected to the plurality of second control signal pins through the second SERDES circuit.

According to an embodiment, an integrated circuit may include a first integrated circuit layer including a plurality of first circuit elements corresponding to a first minimum circuit line width. The integrated circuit may include a second integrated circuit layer disposed over the first integrated circuit layer and including a plurality of second circuit elements corresponding to a second minimum circuit line width smaller than the first minimum circuit line width. The integrated circuit may include a plurality of vias electrically connecting the first integrated circuit layer and the second integrated circuit layer. The first integrated circuit layer may include a first serializer-deserializer (SERDES) circuitry that connects the plurality of first circuit elements to a first via that is some of the plurality of vias. The second integrated circuit layer may include second SERDES circuitry connecting the first via to the plurality of second circuit elements.

According to an embodiment, an application processor (AP) may comprise a first circuit layer including a first serializer-deserializer (SERDES) electronic component connected to each of a first electronic component, at least one second electronic component, and third electronic components including the first electronic component and the at least one second electronic component, a second circuit layer including a fourth electronic component and a second SERDES electronic component connected to the fourth electronic component, and an interconnect layer disposed between the first circuit layer and the second circuit layer. The interconnect layer may include TSVs including a first through silicon via (TSV) connecting the first electronic component to the fourth electronic component and a second TSV connecting the first SERDES electronic component to the second SERDES electronic component. The first electronic component may transmit a signal in a first type to the fourth electronic component through the first TSV in the interconnect layer. The first electronic component may transmit a signal in a second type to the first SERDES electronic component in order to transmit the signal in the second type to the fourth electronic component. The first SERDES electronic component may perform serialization of the signal of the second type together with at least one signal transmitted from the at least one second electronic component. The first SERDES electronic component may transmit a signal obtained based on the serialization to the second SERDES electronic component through the second TSV. The second SERDES electronic component may be configured to obtain the signal in the second type to be transmitted to the fourth electronic component based on demodulation and/or deserialization of the signal transmitted through the second TSV.

According to an embodiment, an application processor (AP) may comprise a first circuit layer including a first electronic component, a plurality of second electronic components including the first electronic component, and a first serializer-deserializer (SERDES) electronic component connected to each of the plurality of second electronic components, a second circuit layer including a third electronic component and a second SERDES electronic component connected to the third electronic component, and an interconnect layer disposed between the first circuit layer and the second circuit layer. The interconnect layer may include a first through silicon via (TSV), configured to directly connect the first electronic component to the third electronic component, and configured to transmit a signal in a first type from the first electronic component to the third electronic component. The interconnect layer may include a second TSV configured to connect the first SERDES electronic component to the second SERDES electronic component and configured to transmit a signal in a second type based on serialization of the first SERDES electronic component. The signal in the second type transmitted through the second TSV may include a sequence of bits of the plurality of second electronic components based on the serialization, including at least one bit provided by the first electronic component.

According to an embodiment, an electronic device may include a memory and an application processor (AP). The AP may include a first circuit layer including a plurality of electronic components including a central processing unit (CPU) and a first serializer-deserializer (SERDES) electronic component connected to each of the plurality of electronic components, a second circuit layer including a memory interface electronic component and a second SERDES electronic component for communicating with the memory, an interconnect layer disposed between the first circuit layer and the second circuit layer. The interconnect layer may include a first through silicon via (TSV) configured to directly connect the CPU of the first circuit layer and the memory interface electronic component. The interconnect layer may include a second TSV configured to connect the first SERDES electronic component and the second SERDES electronic component. The CPU may be configured to transmit a data signal including data to be stored in the memory to the memory interface electronic component through the first TSV. The CPU, which is the first SERDES electronic component, may be configured to transmit a control signal for controlling the memory interface electronic component so that the data is transmitted to the memory.

### [Description of the Drawings]

FIG. 1 illustrates an exemplary hardware configuration of an electronic device including an application processor (AP) according to an embodiment.
FIG. 2 illustrates an exemplary structure of an interconnect layer included in an AP according to an embodiment.
FIGS. 3A, 3B, and 3C illustrate an embodiment of an AP including a plurality of circuit layers connected by an interconnect layer.
FIG. 4 illustrates an exemplary structure of an interconnect layer included in an AP, according to an embodiment.
FIG. 5 illustrates an exemplary structure of an interconnect layer for supporting a plurality of wired communication protocols.
FIG. 6 is an exemplary timing diagram for an electrical signal transmitted from an interconnect layer based on a bi-phase mark coding (BMC) scheme.
FIG. 7 is a block diagram of an electronic device in a network environment according to various embodiments.

### [Mode for Invention]

Hereinafter, various embodiments of the present document will be described with reference to the accompanying drawing.

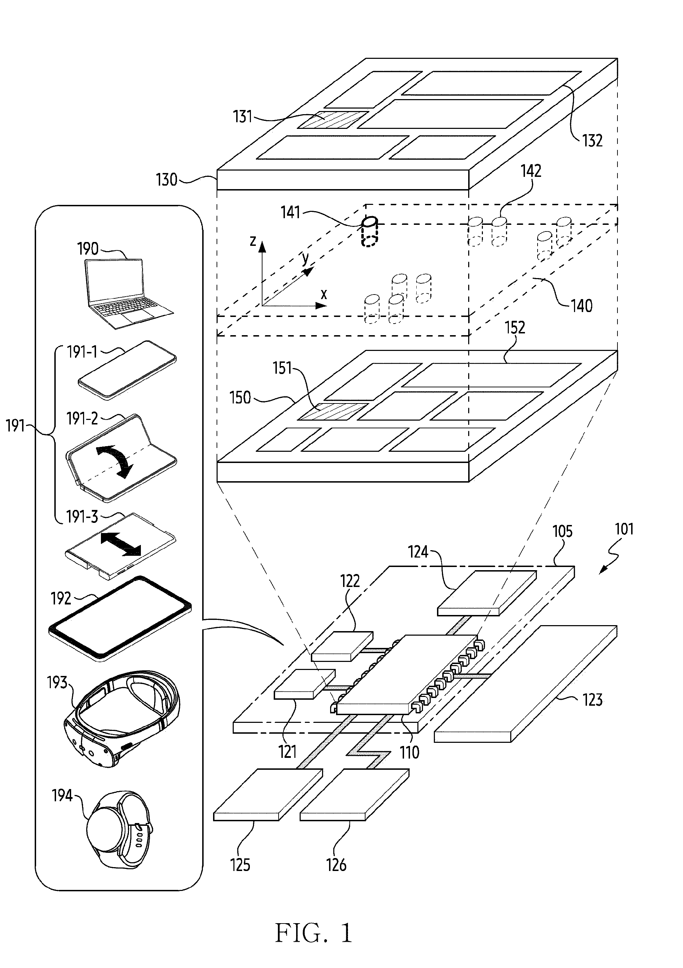

FIG. 1 illustrates an exemplary hardware configuration of an electronic device 101 including an application processor (AP) 110 according to an embodiment.

Referring to FIG. 1, the electronic device 101 may be one of various types of electronic devices, such as a laptop personal computer (PC) 190, smartphones 191 having various form factors (e.g., a bar-type smartphone 191-1, a foldable-type smartphone 191-2, or a slidable (or rollable)-type smartphone 191-3), a tablet PC 192, a head-mounted display (HMD) device 193, a watch 194, a cellular phone (not illustrated), and other similar computing devices (not illustrated). The electronic device 101 may be referred to as a mobile device, a user equipment (UE) (or a user terminal), a multifunction device, a portable device, or a server. A form factor of the electronic device 101 is not limited to exemplary form factors illustrated in FIG. 1. For example, the electronic device 101 may be included as an electronic control unit (ECU) in a vehicle (e.g., an electric vehicle (EV). For example, the electronic device 101 may have a form factor that is wearable by a user, such as an earbud (or a wireless earphone) and/or a ring, or may have a form factor that is implantable on the user's body part.

Components, their relationships, and their functions illustrated in FIG. 1 are illustrative only and do not limit implementations described or claimed in the present document. Referring to FIG. 1, according to an embodiment, the electronic device 101 may include components such as a processor (e.g., an application processor (AP), the communication processor (CP) 110, a memory (e.g., volatile memory 121 and/or non-volatile memory 122), a display 123, communication circuitry 124, an image sensor 125, and/or a sensor 126. For example, the processor may be implemented as a three-dimension integrated circuit (3D-IC) including a plurality of circuit layers.

Referring to FIG. 1, an embodiment in which the processor 110, the volatile memory 121, the non-volatile memory 122, and/or the communication circuitry 124 are disposed over or on a printed circuit board (PCB) 105 is illustrated, but the embodiment is not limited thereto. On the PCB 105, the processor 110 may be electrically and/or operably coupled with the volatile memory 121, the non-volatile memory 122, and/or the communication circuitry 124. Hereinafter, the operably coupling of the components may mean that a direct connection or an indirect connection between the components is established by wire or wirelessly so that a second component is controlled by a first component among the components.

The components included in the electronic device 101 are not limited to an embodiment of FIG. 1, and the electronic device 101 may include other components (e.g., a power management integrated circuit (PMIC), an audio processing circuit, an antenna, a rechargeable battery, or an input/output interface). For example, some components may be omitted from the electronic device 101. For example, several components may be integrated into one component.

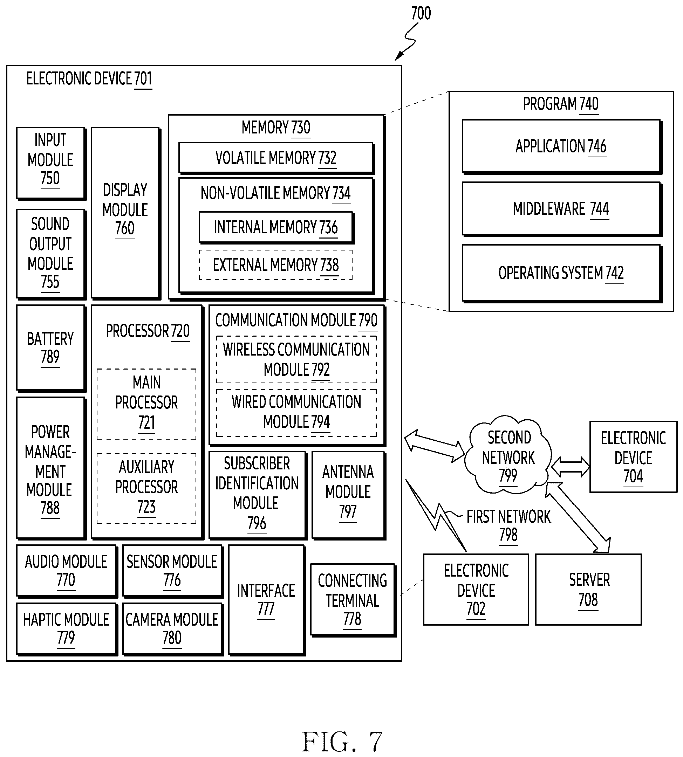

Referring to FIG. 1, the volatile memory 121 and/or the non-volatile memory 122 may be configured to store data and/or instructions based on an address space managed by the processor 110. The display 123 may display an image and/or video provided from the processor 110 on one surface (e.g., a flat surface and/or a curved surface) of a housing of the electronic device 101. The communication circuitry 124 may be configured to support wired communication and/or wireless communication between the electronic device 101 including the processor 110 and the external electronic device. The image sensor 125 may be configured to provide an electrical signal representing external light to the processor 110 and/or the memory (e.g., the volatile memory 121 and/or the non-volatile memory 122). The sensor 126 may be configured to provide an electrical signal based at least on the external environment to the processor 110 and/or the memory (e.g., the volatile memory 121 and/or the non-volatile memory 122). Each of the volatile memory 121, the non-volatile memory 122, the display 123, the communication circuitry 124, the image sensor 125, and the sensor 126 of FIG. 1 may correspond to volatile memory 732, non-volatile memory 734, a display module 760, a communication module 790, a camera module 780, and a sensor module 776 illustrated in FIG. 7.

According to an embodiment, the electronic device 101 may include the processor 110 for processing data. The processor 110 may include a circuit element including a passive element, a transistor, a diode, or a combination thereof. In the processor 110, logical circuitry for processing data may be interconnected with each other. The processor 110 may be referred to as an integrated circuit (IC) and/or a system on chip (SoC). The circuitry included in the processor 110 may be divided into a unit, a module, and/or an electronic component according to a function. For example, the processor 110 may include electronic components such as a central processing unit (CPU), a graphics processing unit (GPU), a neural processing unit (NPU), an image signal processor (ISP), a display controller, a memory controller, a storage controller, an application processor (AP), a communication processor (CP), and/or a sensor interface. Hereinafter, the unit, the module, and/or the electronic component are a set of circuitry included in the processor 110, and may mean at least a portion of the processor 110 designed to execute a specific function. The processor 110 of FIG. 1 may correspond to the processor 120 of FIG. 7.

According to an embodiment, the processor 110 may have a three-dimension integrated circuit (3D-IC) structure in which a plurality of dies are stacked. In terms of including one or more circuit elements, the die may be referred to as a circuit layer and/or an integrated circuit layer (IC layer). A yield of the die (e.g., a defect rate of the die) may decrease as an area of the die decreases (e.g., random fail). Since the processor 110 designed to include the plurality of dies includes dies having a smaller area than a case designed to include a single die, it may be produced with an increased yield than the case with the single die. Hereinafter, "layer" may be used as a term to distinguish dies and/or substrates stacked along a reference direction (in an embodiment of FIG. 1, a direction of a z-axis) in the processor 110. For example, the "layer" may be replaced by terms such as "substrate", "layer", "semiconductor die", and/or "die". The processor 110 may include a plurality of dies based on a silicon wafer. The embodiment is not limited thereto, and a die based on a silicon carbide (SiC) wafer, a gallium nitride (GaN) wafer, a gallium arsenic (GaAs) wafer and/or any other suitable wafer may be included in the processor 110.

According to an embodiment, in the processor 110, a first circuit layer 130 and a second circuit layer 150 are illustrated. The first circuit layer 130 may be disposed (or positioned) above the second circuit layer 150 in the processor 110. Referring to FIG. 1, an exemplary structure of the second circuit layer 150 included in the processor 110 and the first circuit layer 130 disposed over the second circuit layer 150 along the direction (e.g., a vertical direction) of the z-axis is illustrated. The first circuit layer 130 and the second circuit layer 150 may be arranged parallel to a x-y plane in the processor 110. Based on the first circuit layer 130 and/or the second circuit layer 150 disposed along the z-axis direction, circuit elements may have distinct three-dimensional locations in the processor 110. In terms of including the circuit elements having the three-dimensional locations, the processor 110 may be referred to as a three-dimensional integrated circuit (3D-IC), 3D packaging, 3D stacked ICs (SIC), a processing chip component, and a monolithic 3D IC.

According to an embodiment, the processor 110 may include at least one interconnect layer (or connection layer) 140 disposed between the first circuit layer 130 and the second circuit layer 150. The interconnect layer may be referred to as an interposer layer (or interposer). The interconnect layer may be formed based on a material such as silicon, glass, and/or organic compounds.

In an embodiment, the processor 110 may further include other components not illustrated in FIG. 1, as well as the first circuit layer 130, the second circuit layer 150, and the interconnect layer 140 exemplarily illustrated in FIG. 1. For example, the processor 110 may include a substrate, a redistribution layer (RDL), and/or at least one solder ball. The substrate and/or RDL may be disposed under the second circuit layer 150, for example, along a -z axis direction. The processor 110 may include a packaging structure surrounding the above-described component.

In an embodiment, the interconnect layer 140 formed between the first circuit layer 130 and the second circuit layer 150 may include a component for supporting electrical connection between the first circuit layer 130 and the second circuit layer 150. The component may include a through silicon via (TSV). The TSV may be referred to as a through chip via and/or a through hole. The component is not limited to the TSV, and may include another component (e.g., bonding wire) for electrical connection in the z-axis direction. The interconnect layer 140 may be formed in various forms. For example, the interconnect layer 140 may be formed in substantially the same width, height, thickness, area, shape, and/or size as the first circuit layer 130 and/or the second circuit layer 150, but is not limited thereto, and may be formed in various widths, heights, thicknesses, areas, shapes, and/or sizes. According to an embodiment, the interconnect layer 140 may include at least one connection member (e.g., a wire, a solder bump, a metal bump, and other conductive adhesive) based on an access technology different from that of the TSV. The first circuit layer 130 and the second circuit layer 150 may be electrically connected through the connection member included in the interconnect layer 140.

Referring to FIG. 1, an example of an interconnect layer 140 including at least one TSV (e.g., a first TSV 141 and/or a second TSV 142) is illustrated. A plurality of TSVs included in the interconnect layer 140 may be formed based on a via-first process formed before a front end of line (FEOL) process and/or a back end of line (BEOL) process of the first circuit layer 130 and/or the second circuit layer 150. In the via-first process, a plurality of TSVs may be deteriorated or distorted by heat transferred to the interconnect layer 140 in the FEOL process and/or the BEOL process. The embodiment is not limited thereto, and a plurality of TSVs included in the interconnect layer 140 may be formed based on a via-last process formed after the FEOL process and/or the BEOL process. By the via-last process, a plurality of TSVs may be formed independently of heat generated in the FEOL process and/or the BEOL process. While a plurality of TSVs are formed by the via-last process (e.g., an etching process), circuit elements included in the first circuit layer 130 and/or the second circuit layer 140 may be damaged. For example, as the number of TSVs included in the interconnect layer 140 decreases, a yield of the processor 110 may be improved.

According to an embodiment, the processor 110 may include a structure for reducing the number of TSVs included in the interconnect layer 140. For example, the TSV 141 for transmitting a combination (or bundle) of signals and/or information generated from each of the electronic components and/or circuitry included in the first circuit layer 130 may be formed in the interconnect layer 130. In order to generate the combination, the processor 110 may include a first serializer-deserializer (SERDES) circuitry 131 connected to each of the electronic components (e.g., a first circuit element) included in the first circuit layer 130. The first SERDES circuitry 131 may be electrically connected to one end of the TSV 141 adjacent to the first circuit layer 130.

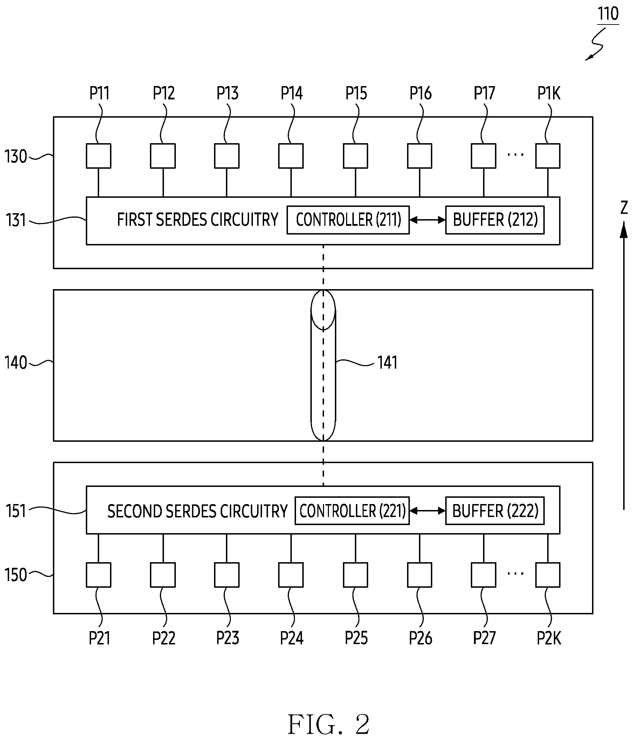

In an embodiment, the processor 110 may include second SERDES circuitry 151 configured to receive a signal or combined information transmitted from the first SERDES through the TSV 141. The second SERDES circuitry 151 may be electrically connected to the other end of the TSV 141 adjacent to the second circuit layer 150. The second SERDES circuitry 151 may be configured to obtain a signal and/or information to be transmitted to at least one of the circuitry included in the second circuit layer 150 from the signal or combination (i.e. the combined information) transmitted from the first SERDES through the TSV 141. The second SERDES circuitry 151 may be included in the second circuit layer 150. The second SERDES circuitry 151 may be connected to each of the circuitry included in the second circuit layer 150. An embodiment in which a combination of signals and/or information generated in the first circuit layer 130 is transmitted to the second circuit layer 150 through the TSV 141 has been described, but the embodiment is not limited thereto, and a combination of signals and/or information generated in each of the circuitry of the second circuit layer 150 may be transmitted to the first circuit layer 130 through the TSV 141. That is, the first SERDES circuitry 131, the second SERDES circuitry 151, and the TSV 141 may enable bidirectional communication between the circuitry in the first circuit layer 130 and the circuitry in the second circuit layer 150. An exemplary structure of the first SERDES circuitry 131 and the second SERDES circuitry 151 connected to both ends of the TSV 141 will be described with reference to FIGS. 2 to 5.

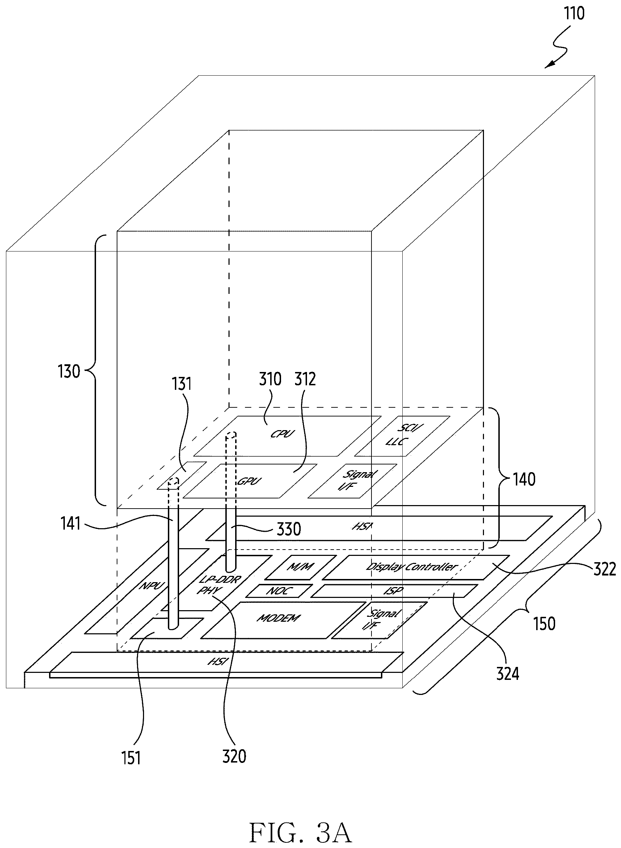

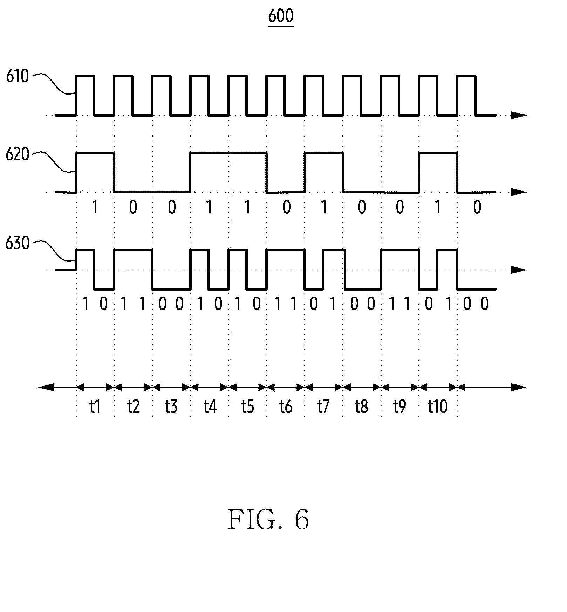

In the processor 110 including the TSV 141, the first SERDES circuitry 131, and the second SERDES circuitry 151 described with reference to FIG. 1, the TSV 141 may be configured to transmit information between circuitry disposed in each of the different circuit layers (e.g., the first circuit layer 130 and/or the second circuit layer 150). Since at least one circuitry of the first circuit layer 130 is electrically connected to the TSV 141 through the first SERDES circuitry 131, and at least one circuitry of the second circuit layer 150 is electrically connected to the TSV 141 through the second SERDES circuitry 151, a specific circuitry in the first circuit layer 130 may be designed to communicate without additional TSV with another circuitry disposed in the second circuit layer 150. For example, TSVs for connecting between at least one circuitry of the first circuit layer 130 and the circuitry of the second circuit layer 150 may not be disposed separately for each circuit, but may be integrated into the TSV 141. In an embodiment, the interconnect layer 140 may further include the TSV 141 connecting the first SERDES circuitry 131 and the second SERDES circuitry 151, and another TSV dedicated to communication between circuitry disposed in different circuit layers. In an embodiment of FIG. 1, the processor 110 may include the TSV 142 configured to electrically connect circuitry 132 of the first integrated circuit layer 130 and circuitry 152 of the second circuit layer 150. The circuitry 132 may directly transmit a signal in a first type (e.g., a signal including data) to the circuitry 152 through the TSV 142. In order to transmit a signal in a second type (e.g., a signal for controlling the circuitry 152) through the TSV 141, the circuitry 132 may transmit the signal in the second type to the first SERDES circuitry 131. For example, according to a type of the signal, data-rate, and/or protocol, any one of the TSVs 141 and 142 may be selected for transmission of the signal. An exemplary operation of the processor 110 and/or circuitry in the processor 110 communicating using the TSVs 141 and 142 will be described with reference to FIGS. 3A to 3C. An example of a communication protocol used by the first SERDES circuitry 131 and the second SERDES circuitry 151 for transmission of the signal in the TSV 141 will be described with reference to FIG. 6.

As described above, according to an embodiment, the processor 110 included in the electronic device 101 may have a structure in which a plurality of signal paths (or signal pins) connecting between circuitry are integrated into a signal path (e.g., the TSV 141 forming a single signal path) less than the number of signal paths. By using an interface structure based on the TSV 141, the first SERDES circuitry 131, and the second SERDES circuitry 151, the processor 110 may support communication between the circuitry 132 disposed in the first circuit layer 130 and the circuitry 152 disposed in the second circuit layer 150. Since the processor 110 is designed and/or produced to have a relatively small number of TSVs based on the interface structure, the yield of the processor 110 may be improved.

For example, the processor 110 (or processing chip component) comprises a first die including first circuitry, second circuitry (e.g. first circuit layer 130), and first SERDES circuitry 131 connected to the first circuitry and the second circuitry; a second die including third circuitry, fourth circuitry (e.g. second circuit layer 150) and second SERDES circuitry 151 connected to the third circuitry and the fourth circuitry; and interconnect layer 140 disposed between the first die and the second die, wherein the interconnect layer 140 includes a first TSV 141 configured to be connected between the first SERDES circuitry 131 and the second SERDES circuitry 151. For example, the first TSV 141 may provide a first signal path between the first circuitry and the third circuitry, a second signal path between the first circuitry and the fourth circuitry, a third signal path between the second circuitry and the third circuitry, and a fourth signal path between the second circuitry and the fourth circuitry. As described above, the first TSV 141 may provide a single signal path through which each of the first, second, third, and fourth signal paths pass.

The first SERDES circuitry 131 may be configured to perform serialization of a signal transmitted from the first circuitry with a signal transmitted from the second circuitry, and to transmit a signal obtained based on the serialization to the second SERDES circuitry 151 through the first TSV 141. The second SERDES circuitry 151 may be configured to obtain the signal to be transmitted to at least one of the third circuitry and the fourth circuitry based on deserialization of the signal transmitted through the first TSV 141. The second SERDES circuitry 151 may also be configured to perform serialization of a signal transmitted from the second circuitry with a signal transmitted from the fourth circuitry, and to transmit a signal obtained based on the serialization to the first SERDES circuitry 131 through the first TSV 141. The first SERDES circuitry 131 may also be configured to obtain the signal to be transmitted to at least one of the first circuitry and the second circuitry based on deserialization of the signal transmitted through the first TSV 141.

The first SERDES circuitry 131 and second SERDES circuitry 151 may be configured to obtain at least one bit corresponding to each of the first signal path, the second signal path, the third signal path and the fourth signal path based on a digit of each of a plurality of bits in a signal transmitted through the first TSV based on deserialization.

The interconnect layer 141 may further include a second TSV 142 connecting the first circuitry to the third circuitry. The second TSV 142 may provide a fifth signal path between the first circuitry and the third circuitry, wherein the fifth signal path does not include the first SERDES circuitry 131 and does not include the second SERDES circuitry 151.

In an example, the first circuitry may be configured to transmit a signal of a first type to the third circuitry through the second TSV 142 in the interconnect layer 140, and to transmit a signal of a second type to the first SERDES circuitry 131 to transmit the signal of the second type to the third circuitry via the first TSV. For example, the first circuitry and third circuitry that are directly (i.e. via TSV 142) and indirectly (i.e. via first SERDES circuitry 131, TSV 141, and second SERDES circuitry 151) connected may selectively use the direct or the indirect connection based on a purpose, data-rate, and/or content of the signal.

For example, the signal of the first type may comprise a data signal to be inputted to the third circuitry, and the signal of the second type may comprise a control signal corresponding to the third circuitry.

Further features related to the first TSV 141 and a second TSV 142 that may be included in the processor 110 of FIG. 1 are described below, for example in relation to FIGS. 2, 3A-3C, 4 and 5.

In an example, the first SERDES circuitry 131 may comprise a buffer for storing bits received from the first circuitry and the second circuitry, wherein each of the bits corresponds to at least one of the first signal path, the second signal path, the third signal path or the fourth signal path. The first SERDES circuitry 131 may comprise a controller configured to generate a sequence of bits to be included in a signal to be transmitted to the second die through the first TSV by performing serialization with respect to the bits stored in the buffer.

In an example, the second SERDES circuitry 151 may comprise a buffer for storing bits received from the third circuitry and the fourth circuitry, wherein each of the bits corresponds to at least one of the first signal path, the second signal path, the third signal path or the fourth signal path. The second SERDES circuitry 151 may comprise a controller configured to generate a sequence of bits to be included in a signal to be transmitted to the first die through the first TSV 141 by performing serialization with respect to the bits stored in the buffer.

The first SERDES circuitry may be configured to store the bits which are obtained from the first circuitry and the second circuitry in a preset time section, into the buffer; and perform the serialization of the bits stored in the buffer based on expiration of the preset time section.

The second SERDES circuitry may be configured to store the bits which are obtained from the third circuitry and the fourth circuitry in a preset time section, into the buffer; and perform the serialization of the bits stored in the buffer based on expiration of the preset time section.

Further features related to the SERDES circuitry (e.g. the buffer and the controller) that may be included in the processor 110 of FIG. 1 are described below, for example in relation to FIGS. 2, 3A-3C, 4 and 5.

The circuitry included in the first die (e.g. the first circuitry and the second circuitry) and the second die (e.g. the third circuitry and the fourth circuitry) may comprise, for example, a central processing unit (CPU), a graphic processing unit (GPU), a serial communication interface (SCI)/last level cache (LLC), a Signal interface (I/F), and a high speed synchronous serial interface (HSI), a memory management (M/M), a neural processing unit (NPU), a low power dynamic random access memory (LP-DDR), a physical interface (PHY), a network on chip (NOC), a display controller, an image signal processor (ISP), and/or a MODEM. However, these are merely examples and the circuitry may comprise any other suitable components.

In an example, the first circuitry may comprise CPU circuitry and the second circuitry my comprise GPU circuitry.

In an example, the third circuitry may comprise ISP circuitry and the fourth circuitry may comprise display controlling circuitry. In another example, the third circuitry may comprise memory interface circuitry to communicate with a memory connected to the processing chip component; and the fourth circuitry may comprise NPU circuitry.

In an example where the first circuitry comprises CPU circuitry, the second circuitry comprises GPU circuitry, the third circuitry comprises ISP circuitry, and the fourth circuitry comprises display controlling circuitry, the CPU circuitry may include a first signal pin connected to the first SERDES circuitry 131, and a second TSV 142 may be connected to a second signal pin of the CPU circuitry. The ISP circuitry may comprise a third signal pin which is electrically connected to the second TSV 142. The CPU circuitry may be configured to transmit a control signal to request data from the ISP circuitry, to the first SERDES circuitry 131 through the first signal pin, and receive, through the second signal pin connected to the second TSV 142, the data corresponding to the control signal from the ISP circuitry.

Further features related to signal pins that may be included in the processor 110 of FIG. 1 are described below, for example in relation to FIGS. 2, 3A-3C, 4 and 5.

In an example in which the first circuitry comprises a CPU, the second SERDES circuitry 151 may be configured to: receive, from the third circuitry, a signal for notifying, to the first circuitry, at least one of a state of the third circuitry or an interruption (e.g. a software interrupt) associated with the third circuitry.

In an example, the first die may be configured to comprise a circuit element having a size smaller than minimum size of circuit elements included in the second die. For example, the first die may comprise circuitry produced by a process capable of implementing a circuit element based on a first minimum line width (e.g., a 3nm process and/or a 2nm process), and the second die may comprise circuitry produced by a process capable of implementing a circuit element based on a second minimum line width that is greater than the first minimum line width.

In an example, the first SERDES circuitry 131 may be configured to transmit a signal that is obtained based on serialization and encoded based on bi-phase mark coding (BMC) scheme, to the second SERDES 151 circuitry through the first TSV 141. Further features related to the BMC scheme that may be included in the processor 110 of FIG. 1 are described below, for example in relation to FIG. 6.

In an example, a power state of at least one of the first SERDES circuitry 131 and the second SERDES circuitry 151 may be controlled independently of a power state of a CPU included in the processing chip component. Further features related to the state of the SERDES circuitry that may be included in the processor 110 of FIG. 1 are described below, for example in relation to FIGS. 3A to 3C.

In an example, the interconnect layer 140 may comprise an auxiliary TSV configured to be connected between the first SERDES circuitry 131 and the second SERDES circuitry 151, and to provide an auxiliary first signal path between the first circuitry and the third circuitry, an auxiliary second signal path between the first circuitry and the fourth circuitry, an auxiliary third signal path between the second circuitry and the third circuitry, and an auxiliary fourth signal path between the second circuitry and the fourth circuitry.

The first die may comprise a first switching circuit and the second die may comprise a second switching circuit. The first switching circuit and the second switching circuit may be configured to control a connection between the first SERDES circuitry 131 and the second SERDES circuitry 151 by switching the connection between the first TSV and the auxiliary TSV.

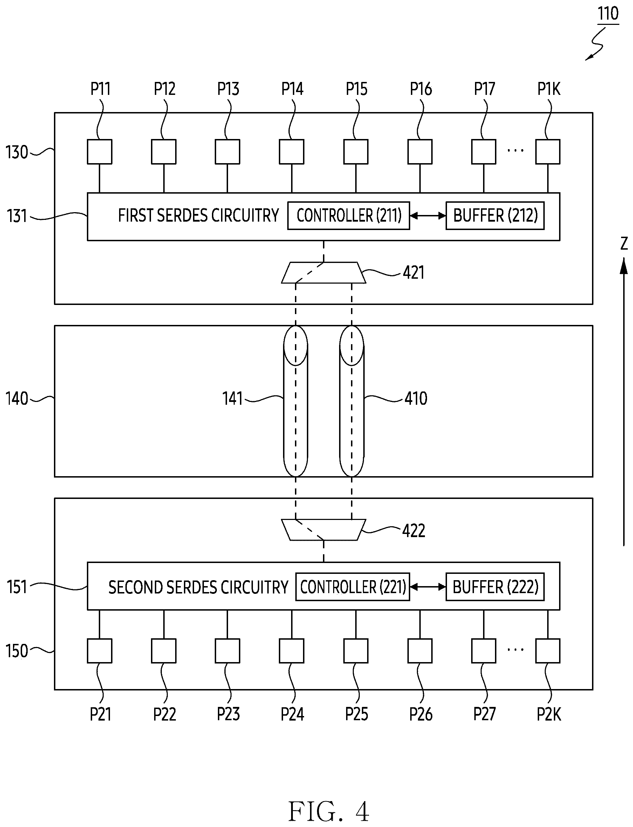

Further features related to the auxiliary TSV that may be included in the processor 110 of FIG. 1 are described below, for example in relation to FIG. 4.

In an example, the interconnect layer comprises a plurality of TSVs; wherein the first SERDES circuitry comprises: first protocol circuitry configured to support a first communication protocol, second protocol circuitry configured to support a second communication protocol, and a first multiplexer switching circuit configured to connect the plurality of TSVs to the first protocol circuitry and second protocol circuitry; wherein the second SERDES circuitry comprises: third protocol circuitry configured to support the first communication protocol, fourth protocol circuitry configured to support the second communication protocol, and a second multiplexer switching circuit configured to connect the plurality of TSVs to the third protocol circuitry and fourth protocol circuitry; and wherein the first multiplexer switching circuit and the second multiplexer switching circuit are configured to: select a communication protocol, establish a connection between the first protocol circuitry and the third protocol circuitry via the plurality of TSVs in the case that the first communication protocol is selected, and establish a connection between the second protocol circuitry and the fourth protocol circuitry via the plurality of TSVs in the case that the second communication protocol is selected.

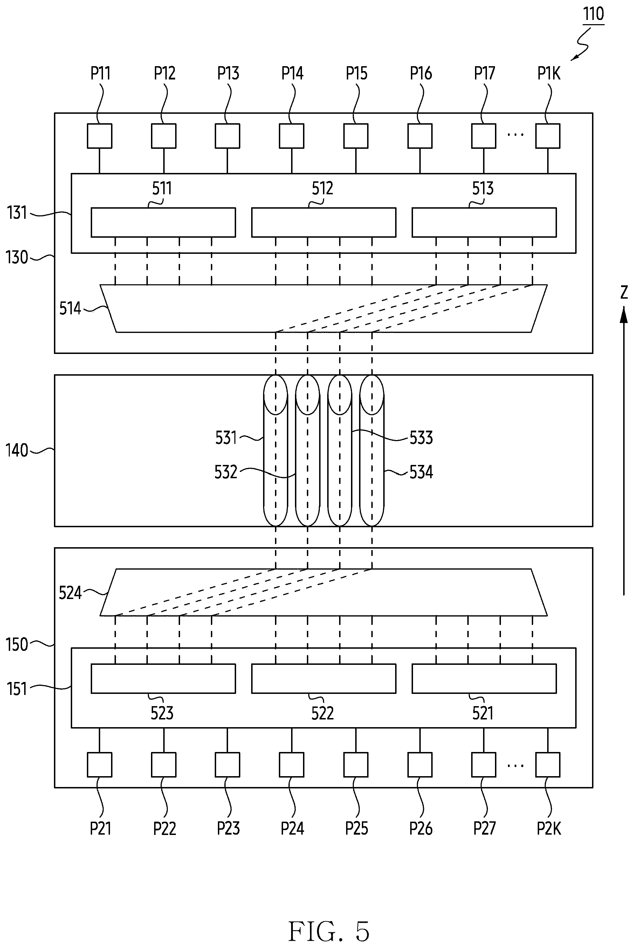

Further features related to the protocol circuitry that may be included in the processor 110 of FIG. 1 are described below, for example in relation to FIG. 5.

Hereinafter, an exemplary structure of an inter-circuit layer connection between circuit layers formed by the first SERDES circuitry 131, the second SERDES circuitry 151, and the TSV 141 will be described with reference to FIG. 2.

FIG. 2 illustrates an exemplary structure of an interconnect layer 140 included in a processor 110 according to an embodiment. At least a portion of the processor 110 illustrated in FIG. 2 may correspond to at least a portion of the processor 110 illustrated in FIG. 1, and features described above in relation to the processor 110 of FIG. 1 can be included in the processor 110 of FIG. 2, even if not illustrated or specifically described below.

Referring to FIG. 2, a second circuit layer 150, the interconnect layer 140, and a first circuit layer 130 sequentially stacked along a z-axis direction in the processor 110 are illustrated. In the interconnect layer 140, a TSV 141 for integrally transmitting signals (e.g., signals based on general purpose input-output (GPIO)) transmitted between the first circuit layer 130 and the second circuit layer 150 may be formed. In order to integrally transmit the signals through a single signal path such as the TSV 141, the first SERDES circuitry 131 and the second SERDES circuitry 151 may be disposed at both ends of the TSV 141. For example, when the first SERDES circuitry 131 integrally transmits signals of circuitry of the first circuit layer 130, the second SERDES circuitry 151 may distribute the integrated signals to each of circuitry of the second circuit layer 150. Conversely, when the second SERDES circuitry 151 integrally transmits signals of the circuitry of the second circuit layer 150, the first SERDES circuitry 131 may distribute the integrated signals to each of the circuitry of the first circuit layer 130.

According to an embodiment, the SERDES circuitry (e.g., the first SERDES circuitry 131 and/or the second SERDES circuitry 151) may include pins (or signal pins) for electrically connecting to other circuitry (e.g., circuitry included in the circuit layer (e.g., the first integrated circuit layer 130 and/or the second integrated circuit layer 150) on which the SERDES circuitry is disposed). Referring to FIG. 2, the first SERDES circuitry 131 including k pins (e.g., p11, p12, ..., p1k) and the second SERDES circuitry 151 including k pins (e.g., p21, p22, ..., p2k) are exemplarily illustrated, but the number of pins extended from the SERDES circuitry is not limited thereto. The k pins of the first SERDES circuitry 131 may be electrically connected to different circuitry disposed in the first circuit layer 130. Similarly, the k pins of the second SERDES circuitry 151 may be electrically connected to different circuitry disposed in the second circuit layer 150.

In an embodiment, the SERDES circuitry (e.g., the first SERDES circuitry 131 and/or the second SERDES circuitry 151) may receive an electrical signal including one or more bits from another circuitry through at least one pin. For example, the one or more bits may indicate a numeric value corresponding to a state of the other circuit. For example, the one or more bits may indicate an interrupt (e.g., a software interrupt) generated in the other circuit. The one or more bits indicating the interrupt may indicate a type of the interrupt and/or a numeric value uniquely assigned to the interrupt. For example, circuitry disposed on a specific circuit layer may transmit an electrical signal to the SERDES circuitry connected to the circuitry, in order to notify at least one of the state of the circuitry and/or an interrupt related to the circuitry to circuitry disposed on another circuit layer.

In an embodiment, the SERDES circuitry may include a buffer for storing signals independently received through different pins and/or bits included in the signals. Referring to FIG. 2, the first SERDES circuitry 131 may include a buffer 212 for storing bits received through k pins. The second SERDES circuitry 151 may include a buffer 222 for at least partially storing signals received through k pins. In each of the buffers 212 and 222, bits indicating states of circuitry included in each of the first circuit layer 130 and the second circuit layer 150 and/or interrupts generated in the circuitry may be stored.

In an embodiment, the SERDES circuitry may include a controller for performing serialization of bits stored in the buffer or for performing deserialization of bits included in a signal received through the TSV 141. Referring to FIG. 2, a controller 211 included in the first SERDES circuitry 131 and a controller 221 included in the second SERDES circuitry 151 are exemplarily illustrated. The controller 211 of the first SERDES circuitry 131 may obtain a plurality of bits to be included in a signal to be transmitted to the second circuit layer 150 and/or the second SERDES circuitry 151 through the TSV 141, by combining the bits stored in the buffer 212. Similarly, the controller 221 of the second SERDES circuitry 151 may obtain a sequence of bits to be transmitted to the first circuit layer 130 and/or the first SERDES circuitry 131 through the TSV 141, by combining the bits stored in the buffer 222.

In an embodiment, the first SERDES circuitry 131 or the second SERDES circuitry 151 may be implemented by including a parallel in serial out (PISO) function block, a serial in parallel out (SIPO) function block, or a clock circuit, and the like, without the controller.

In an embodiment, combination of bits performed by the controller 211 of the first SERDES circuitry 131 and/or the controller 221 of the second SERDES circuitry 151 may include serialization. The serialization may include an operation of obtaining a sequence (e.g., bitstream) of bits to be transmitted sequentially through a single signal path (or lane) such as the TSV 141. For example, the controller 211 may generate or obtain the sequence of the bits by concatenating bits stored in the buffer 212 and/or bits received through the pins (p11 to p1k). Locations of each of the bits in the sequence may be determined based on the pin at which the bit was received. For example, Table 1 exemplarily shows bits received through four pins (p11 to p14).

**[Table 1]**

| pin | p11 | p12 | p13 | p14 |
|---|---|---|---|---|
| bit | 1 | 0 | 1 | 1 |

The controller 211 of the first SERDES circuitry 131 that received the bits illustrated in the Table 1 may generate a sequence 1011 of bits by sequentially combining the bit 1 received through the pin p11, the bit 0 received through the pin p12, the bit 1 received through the pin p13, and the bit 1 received through the pin p14. Based on the above-described operation, the controller 211 may generate a sequence of k bits received from k pins. The controller 211 may transmit a signal indicating the sequence through the TSV 141.

In an embodiment in which the first SERDES circuitry 131 is connected to each of k different circuitry through k pins, timings at which the k circuitry transmit signals to the first SERDES circuitry 131 may be different from each other. In an exemplary case of receiving the bits of the Table 1, the timing of receiving the bit 0 through the pin p12 and the timing of receiving the bit 1 through the pin p11 may be the same or different. According to an embodiment, the controller 211 may accumulate or store bits included in signals transmitted from different circuitry during a preset time section (e.g., about 5 ms (milliseconds)), in the buffer 212. For example, in the time section divided based on a preset period, the controller 211 may receive at least one bit to be included in a signal to be transmitted to the TSV 141.

Based on expiration (or upon expiration) of the time section, the controller 211 may perform serialization of the bits stored in the buffer 212. In case that a specific circuitry does not transmit any signal in the time section, the controller 211 may perform the serialization based on bits that were transmitted from the specific circuitry before the time section (e.g., stored in the buffer 212 before the time section).

In an embodiment, whenever a signal occurs on any one pin among the k pins (e.g., p11, p12, ..., p1k), the first SERDES circuitry 131 may transmit the corresponding signal to the second SERDES circuitry 151 through the TSV 141. In an embodiment, the first SERDES circuitry 131 may transmit the corresponding signal to the second SERDES circuitry 151 regardless of the transmission period, by identifying a pin or signal having a preset name or format among k pins (e.g., p11, p12, ..., p1k). In an embodiment, when a signal is generated from the pin having the preset name or format, the first SERDES circuitry 131 may perform serialization of the signals that have occurred up to that point, even if the transmission period has not yet been reached. The first SERDES circuitry 131 may transmit a signal generated and/or obtained by the serialization to the second SERDES circuitry 151.

Referring to the Table 1, an embodiment of the first SERDES circuitry 131 connected to k different circuitry through k pins has been described, but the embodiment is not limited thereto. For example, at least two pins among the k pins may be configured to connect the first SERDES circuitry 131 to one circuit. For example, the circuitry connected to the first SERDES circuitry 131 through the two pins may transmit a signal including two bits. By using the signal, the circuitry may notify the current state of the circuit, selected from a maximum of four states.

According to an embodiment, the first SERDES circuitry 131 may transmit a signal (e.g., a signal including a sequence of bits) obtained based on the above-described operation (e.g., serialization) to the second SERDES circuitry 151 through the TSV 141. The controller 221 of the second SERDES circuitry 151 that received the signal may to obtain at least one bit to be provided to at least one circuitry of the second circuit layer 150, by performing deserialization or reserialization on the received signal. For example, the controller 221 may obtain or generate signals to be transmitted to circuitry of the second circuit layer 150 based on the deserialization.

For example, the controller 221 that received the sequence of bits received through the TSV 141 may allocate the plurality of bits to different pins based on the locations of each of the plurality of bits in the sequence. The second SERDES circuitry 151 that received a signal including a sequence of k bits through the TSV 141 may allocate bits disposed at different digits in the sequence, to k pins (e.g., p21, p22, ..., p2k). For example, the second SERDES circuitry 151 that received the sequence 1011 of bits through the TSV 141 may output 2³-digit bits 1 to pins p21, 2²-digit bits 0 to pins p22, 2¹-digit bits 1 to pins p23, and 2⁰-digit bits 1 to pins p24, in the sequence. In case that the second SERDES circuitry 151 is connected to the circuitry of the second circuit layer 150 through different pins, different bits in the sequence may be transmitted to the circuitry through the pins.

As described above, based on serialization in the first SERDES circuitry 131 and deserialization in the second SERDES circuitry 151, the bits inputted to the specific pins of the first SERDES circuitry 131 may be outputted through the pins corresponding to the specific pins in the second SERDES circuitry 151. For example, the pins of the first SERDES circuitry 131 may be matched one on one with the pins of the second SERDES circuitry 151. Based on a one on one relationship between the pins of the first SERDES circuitry 131 and the pins of the second SERDES circuitry 151, an exclusive connection between a specific circuitry of the first circuit layer 130 and another circuitry of the second circuit layer 150 may be established through the TSV 141. In an embodiment of FIG. 2, up to k exclusive connections may be established based on the first SERDES circuitry 131, the second SERDES circuitry 151, and the TSV 141. In other words, since k exclusive connections are integrated into one TSV 141, the processor 110 may be designed and produced with a relatively small number of TSVs. Since the processor 110 has a relatively small number of TSVs, a yield of the processor 110 may be improved.

Referring to FIG. 2, an embodiment of transmitting the signal from the first SERDES circuitry 131 to the second SERDES circuitry 151 has been described, but the embodiment is not limited thereto. For example, the controller 221 of the second SERDES circuitry 151 may perform serialization of signals and/or bits stored in the buffer 222 in the preset time section. Based on the serialization, bits received through different pins (p21, p22, ..., p2k) in the preset time section may be integrated into one bitstream. The controller 221 may transmit a signal including the bitstream to the first circuit layer 130 and/or the first SERDES circuitry 131 through the TSV 141. The first SERDES circuitry 131 and/or the controller 211 that received the signal through the TSV 141 may divide bits included in the bitstream based on deserialization. The bits divided based on the locations in the bitstream may be outputted through different pins (p11, p12, ..., p1k) of the first SERDES circuitry 131 by the controller 211. In case that the pins are connected to different circuitry of the first circuit layer 130, the bits outputted through the pins (p11, p12, ..., p1k) may be transmitted to the circuits.

As described above, based on the first SERDES circuitry 131, the TSV 141, and the second SERDES circuitry 151 included in the processor 110, signals of different circuitry may be integrally transmitted through the TSV 141. In terms of integrating signals, a SERDES circuit, such as the first SERDES circuitry 131 and/or the second SERDES circuitry 151, may be referred to as a signal coupling circuit and/or a signal modulator. The signal transmitted through the TSV 141 may be divided into one or more signals to be transmitted to different circuitry by the SERDES circuit. In terms of dividing the signal, the SERDES circuit, such as the first SERDES circuitry 131 and/or the second SERDES circuitry 151, may be referred to as a signal division circuit and/or a signal demodulator.

Hereinafter, an exemplary structure of the processor 110 including the first SERDES circuitry 131, the TSV 141, and the second SERDES circuitry 151 described with reference to FIG. 2 will be described.

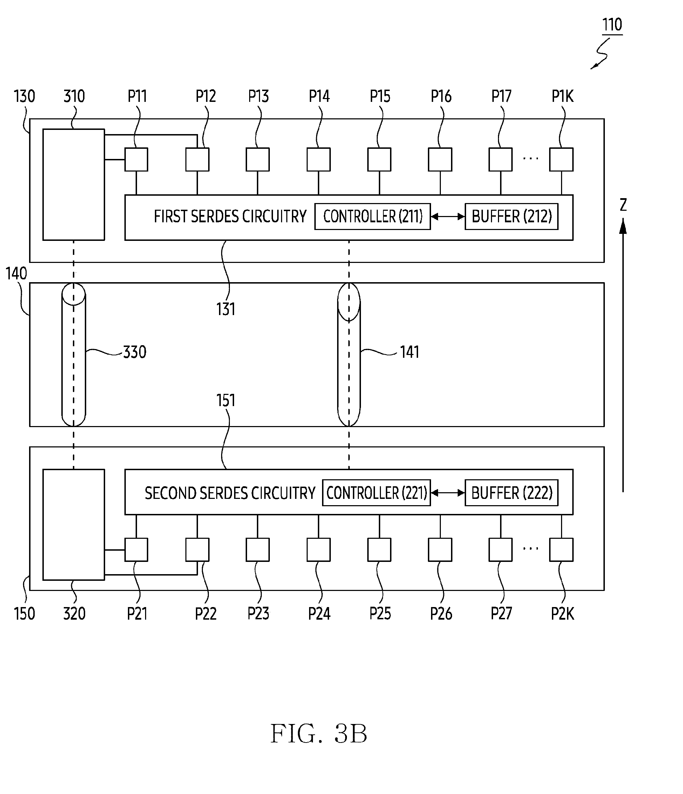

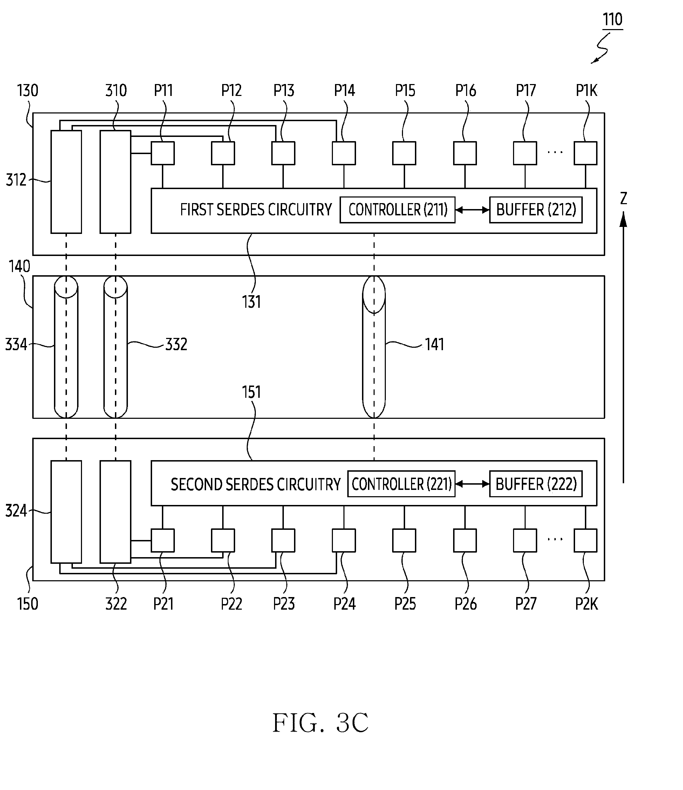

FIG. 3A, FIG. 3B, and FIG. 3C illustrate an embodiment of a processor 110 including a plurality of circuit layers (e.g., a first circuit layer 130 and/or a second circuit layer 150) connected by an interconnect layer 140. At least a portion of the processor 110 illustrated in FIGS. 3A to 3C may correspond to at least a portion of the processor 110 of FIG. 1 and/or FIG. 2, and features described above in relation to the processor 110 of FIG. 1 and/or FIG. 2 can be included in the processor 110 of FIGS. 3A to 3C, even if not illustrated or specifically described below.

Referring to FIG. 3A, for convenience of explanation, circuitry included in the processor 110 are illustrated in the form of blocks in each of the first circuit layer 130 and the second circuit layer 150. As an example of circuitry included in the processor 110, a central processing unit (CPU) 310, a graphic processing unit (GPU) 312, a serial communication interface (SCI)/last level cache (LLC), a Signal interface (I/F), and a high speed synchronous serial interface (HSI), a memory management (M/M), a neural processing unit (NPU), a low power dynamic random access memory (LP-DDR), a physical interface (PHY) 320, a network on chip (NOC), a display controller 322, an image signal processor (ISP) 324, and/or a MODEM are illustrated. The circuitry included in the processor 110 are not limited to an embodiment of FIG. 3A, and the processor 110 may further include circuitry not illustrated in FIG. 3A, or some of the circuitry of FIG. 3A may be excluded from the processor 110.

Referring to FIG. 3A, an embodiment in which the CPU 310 and/or the GPU 312 are disposed in the first circuit layer 130 and the NPU and/or the MODEM are disposed in the second circuit layer 150 is illustrated, but the embodiment is not limited thereto. For example, circuitry illustrated as different blocks in each of the first circuit layer 130 and the second circuit layer 150 may be disposed at a different location and/or die from the embodiment of FIG. 3A. For example, based on a heat dissipation structure in the processor 110, locations of the circuitry may be determined as either the first circuit layer 130 and/or the second circuit layer 150.

For example, the CPU 310 may include circuitry configured to process data based on at least one instruction inputted to the CPU 310. The GPU 312 may include circuitry configured to execute a parallel operation (e.g., rendering) for a graphic. An NPU (or neural engine) may include circuitry configured to execute an operation (e.g., convolution computation) for an artificial intelligence model. The SCI/LLC may include circuitry configured to at least temporarily store data to be processed by the CPU 310, the GPU 312, and/or the NPU. The signal I/F may include circuitry configured to control transmission of a signal in a circuit layer (e.g., the first circuit layer 130 and/or the second circuit layer 150). The HSI may include circuitry configured to transmit the signal at a relatively high speed between circuitry in the circuit layer (e.g., the first circuit layer 130 and/or the second circuit layer 150). The M/M may include circuitry for conversion between a virtual address and a physical address, in order to access data stored in a memory (e.g., volatile memory 121 and/or non-volatile memory 122 of FIG. 1) connected to the processor 110. The LP-DDR PHY 320 may include circuitry for direct transmission and/or reception of data between the volatile memory (e.g., the volatile memory 121 of FIG. 1) connected to the processor 110 and the CPU 310. The NOC may include circuitry configured to control transmission and reception of a signal between circuitry in the processor 110. The display controller 322 may include circuitry for controlling a display electrically connected to the processor 110 by using data (e.g., an image and/or video based on rendering) provided from the CPU 310 and/or the GPU 312. The image signal processor (ISP) 324 may include circuitry for controlling a camera electrically connected to the processor 110 and/or receiving the camera and data (e.g., an image, a video, and/or an image frame obtained by the camera). The MODEM may include circuitry configured to control communication circuitry (e.g., communication circuitry 124 of FIG. 1) connected to the processor 110.

The above-described circuitry may be disposed on any one circuit layer among the first circuit layer 130 and the second circuit layer 150 produced based on different processes in the processor 110. For example, the minimum size of the first circuit elements included in the first circuit layer 130 may be smaller than the minimum size of the second circuit elements included in the second circuit layer 150. The first circuit layer 130 may be produced by a first process (e.g., a 3nm process and/or a 2nm process) capable of implementing a circuit element (e.g., a transistor having a gate-all-round (GAA) structure) based on a minimum line width (or line pitch) of 3 nm. The second circuit layer 150 may be produced by a second process that supports production of a circuit element (e.g., a transistor having a fin field-effect transistor (FinFET) structure) with a minimum line width greater than 3 nm. The process corresponding to the first circuit layer 130 and the second circuit layer 150 is not limited to the first process and the second process described above.

In an embodiment, circuitry (e.g., the CPU, the ISP, the MODEM, the NPU, and/or the GPU) described as integrated in the processor 110 may be implemented or may be produced as an independent integrated circuit. In the embodiment, the integrated circuit including at least one of the CPU, the ISP, the MODEM, the NPU, and/or the GPU described above may be implemented as a 3D-IC including circuit layers (e.g., semiconductor die layers) stacked therein and a series connection wiring (e.g., TSV) connecting the stacked circuit layers.

In an embodiment, performance (e.g., performance measured by a parameter such as an instructions per cycle (IPC) and/or a floating point operations per second (FLOPS)) of the circuit layer, power consumption, and/or yield may be related to a process used in the production of the circuit layer. The circuitry included in the processor 110 may be disposed in either the first integrated circuit layer 130 or the second integrated circuit layer 150 based on required performance, power consumption, and/or yield. Referring to FIG. 3A, the processor 110 including the first circuit layer 130 including the CPU 310, the GPU 312, and the SCI/LLC, and the second circuit layer 150 including the NPU, HIS, the LP-DDR PHY 320, the MODEM, the M/M, and the NOC is exemplarily illustrated, but embodiment is not limited thereto.

Referring to FIG. 3A, the first circuit layer 130 of the processor 110 may include first SERDES circuitry 131 connected to each of a plurality of circuitry (e.g., the first circuit element) of the first integrated circuit layer 130, including the CPU 310. The second circuit layer 150 of the processor 110 may include second SERDES circuitry 151 connected to each of a plurality of circuitry of the second circuit layer 150, including a memory interface circuit for communicating with the memory (e.g., the volatile memory 121 of FIG. 2), such as the LP-DDR PHY 320. The processor 110 may include the interconnect layer 140 disposed between the first circuit layer 130 and the second circuit layer 150.

In an embodiment, the interconnect layer 140 may include one or more signal paths for electrically and/or operably connecting circuitry of the first circuit layer 130 and circuitry of the second circuit layer 150. The signal path may be established by the TSV. Referring to FIG. 3A, as an example of the signal path, a TSV 141 configured to connect the first SERDES circuitry 131 and the second SERDES circuitry 151 is illustrated. Through the TSV 141, a signal for notifying a state and/or interrupt of another circuitry may be transmitted between the first SERDES circuitry 131 and the second SERDES circuitry 151. The signal may be transmitted at a relatively slow data-rate (e.g., included in a data-rate range of 300 kbps to 5 Mbps, or at a data-rate less than or equal to the data-rate range). In terms of supporting a relatively slow speed, the interface established based on the TSV 141 may be referred to as low speed input/output (IO). In order to transmit the signal through the single TSV 141, the first SERDES circuitry 131 and/or the second SERDES circuitry 151 may transmit the signal based on a 1-wire protocol, such as a bi-phase mark coding (BMC) method.

In an embodiment, based on the first SERDES circuitry 131 and the second SERDES circuitry 151 connected to both ends of the TSV 141, a signal path that may be used by all of the circuitry included in the first circuit layer 130 and the second circuit layer 150 may be established. The embodiment is not limited thereto, and the interconnect layer 140 of the processor 110 may include one or more signal paths dedicated to a pair of circuitry disposed in each of the first circuit layer 130 and the second circuit layer 150.

Referring to FIG. 3A, a TSV 330 for electrical connection between the CPU 310 and the LP-DDR PHY 320 may be formed in the interconnect layer 140. For high-speed communication between the CPU 310 and the LP-DDR PHY 320, a plurality of TSVs including the TSV 330 may be formed. The high-speed communication may include peripheral component interconnect bus express (PCIe), universal serial bus (USB), mobile industry processor interface (MIPI), Marconi, universal flash storage (UFS), memory interface (MIF), inter-integrated circuit (I2C), and/or improved inter-integrated circuit (I3C). For the high-speed communication, a differential interface based on a plurality of TSVs (or signal paths) may be formed between circuits. For the high-speed communication, any one TSV among a plurality of TSVs may be used for transmission of a clock signal.

Referring to FIG. 3A, the signal path between the first circuitry (e.g., the CPU 310) of the first circuit layer 130 and the second circuitry (e.g., the LP-DDR PHY 320) of the second circuit layer 150 may be divided into a first signal path that directly connects the first circuitry and the second circuitry, and a second signal path that indirectly connects the first circuitry and the second circuitry based on the SERDES circuit. The TSV 330 may correspond to at least a portion of the first signal path. The TSV 141, the first SERDES circuitry 131, and/or the second SERDES circuitry 151 may correspond to at least a portion of the second signal path.

In an embodiment, circuitry directly and indirectly connected through the first signal path and the second signal path may selectively use any one of the signal paths based on a purpose, data-rate, and/or content of the signal. For example, the first signal path including the TSV 330 may be used to transmit a data signal (e.g., a signal including data to be transmitted to the volatile memory through the LP-DDR PHY 320). For example, the second signal path, including the TSV 141, may be used to transmit a control signal (e.g., a signal generated by the CPU 310 to adjust a state of the LP-DDR PHY 320).

Referring to FIG. 3B, an exemplary block diagram for describing the first signal path and the second signal path formed by TSVs 141 and 330 is illustrated. In order to transmit a data signal based on the TSV 330, data signal pins included in the CPU 310 and/or the LP-DDR PHY 320 may be directly connected through the TSV 330. For transmission of the control signal based on the TSV 141, one or more control signal pins for transmission of the control signal to be transmitted to the LP-DDR PHY 320 among the pins of the CPU 310 may be connected to one or more pins P11 and P12 of the first SERDES circuitry 131. For example, the one or more control signal pins may be connected to the TSV 141 through the first SERDES circuitry 131. For example, a first control signal pin for transmitting a signal related to an interrupt may be connected to a pin P11 of the first SERDES circuitry 131. For example, a second control signal pin for transmitting a signal for controlling the state of the LP-DDR PHY 320, such as a reset, may be connected to a pin P12 of the first SERDES circuitry 131. The embodiment is not limited thereto.

In an embodiment of FIG. 3B, the CPU 310 may transmit a signal in a first type for data transmission to the LP-DDR PHY 320 through the TSV 330. For example, a data signal including data to be stored in a memory connected to the processor 110 may be transmitted from the CPU 310 to the LP-DDR PHY 320 through the TSV 330. In the TSV 330 exclusively connecting the CPU 310 and the LP-DDR PHY 320, the signal in the first type may be transmitted at a speed of a first data-rate range.

In an embodiment of FIG. 3B, the CPU 310 may transmit a signal in a second type for controlling the controller of the LP-DDR PHY 320 to the first SERDES circuitry 131 through any one of the pins P11 and P12. For example, a control signal that adjusts the state of the LP-DDR PHY 320 or controls the execution of a specific function (e.g., a function of transmitting data included in the signal in the first type to a memory) and/or an operation (or computation) of the LP-DDR PHY 320 may be transmitted from the CPU 310 to the first SERDES circuitry 131. For example, a control signal for transmitting data provided to the LP-DDR PHY 320 to the memory through the TSV 330 may be transmitted from the CPU 310 to the first SERDES circuitry 131.

In an embodiment of FIG. 3B, the CPU 310 may include a plurality of sub-circuitry. Each of the plurality of sub-circuitry may correspond to different pins P11 and P12 and/or different TSVs 141 and 330. For example, the plurality of sub-circuitry of the CPU 310 may include first sub-circuitry connected to the first SERDES circuitry 131 to transmit the signal in the second type to the TSV 141 through the first SERDES circuitry 131. The first sub-circuitry of the CPU 310 may be connected to the first SERDES circuitry 131 through at least one of the pins P11 and P12. The first sub-circuitry of the CPU 310 may include a memory address register (MAR) and/or a control circuit in the CPU 310 to transmit a control signal corresponding to the LP-DDR PHY 320. A plurality of sub-circuitry of the CPU 310 may include second sub-circuitry connected to the TSV 330 to transmit the signal in the first type. The second sub-circuitry of the CPU 310 is a sub-circuitry for transmitting a data signal to be inputted to the LP-DDR PHY 320 and may include a memory buffer register (MBR) and/or a cache memory (e.g., L1, L2 and/or L3 cache memory).

In an embodiment, similar to the CPU 310, which includes sub-circuitry configured to connect directly and/or indirectly with different TSVs (e.g., indirect connection through the first SERDES circuitry 131 and/or the second SERDES circuitry 151), each of the circuitry (e.g., the GPU 312, SCI/LLC, Signal I/F, HSI, M/M, NPU, LP-DDR PHY 320, NOC, display controller, ISP 324, and/or MODEM) included in the processor 110 may include sub-circuitry corresponding to at least one of TSVs in the interconnect layer 140 such as the TSV 141. For example, the GPU 312 may include sub-circuitry corresponding to each of a plurality of TSVs directly and/or indirectly connected to the GPU 312, including the TSV 141. The circuitry in the processor 110 may include the sub-circuitry corresponding to each of the TSVs used by the circuit. The embodiment is not limited thereto, and the number of sub-circuitry included in the circuitry in the processor 110 may exceed or be small than the number of the TSVs used by the circuit.

As described above with reference to FIG. 2, the first SERDES circuitry 131 may perform modulation and/or serialization of signals transmitted from circuitry of the first circuit layer 130 including the CPU 310. For example, by performing serialization of control signals transmitted from the circuits, the first SERDES circuitry 131 may obtain a signal including a sequence of bits included in the control signals. The first SERDES circuitry 131 may transmit the obtained signal through the TSV 141. In an embodiment in which the circuitry independently transmit control signals, the first SERDES circuitry 131 may transmit the control signals transmitted at different timings to the second SERDES circuitry 151 based on a preset period. In the TSV 141, a signal generated based on serialization of the first SERDES circuitry 131 or the second SERDES circuitry 151 may be transmitted at a speed of the second data-rate range less than or equal to the first data-rate range.

In an embodiment of FIG. 3B, the second SERDES circuitry 151 that received the signal based on the serialization of the first SERDES circuitry 131 through the TSV 141 may divide a plurality of bits included in the signal, by performing deserialization. The second SERDES circuitry 151 may allocate the plurality of bits to the pins of the second SERDES circuitry 151 based on relationship between the pins of the first SERDES circuitry 131 and the pins of the second SERDES circuitry 151. For example, control signal pins of the LP-DDR PHY 320, which is a target of the control signal transmitted to the pins P11 and P12, may be connected to the pins P21 and P22 corresponding to the pins P11 and P12 of the first SERDES circuitry 131, respectively. The LP-DDR PHY 320 may receive one or more bits transmitted from the CPU 310 to the pins P11 and P12 through the pins P21 and P22. The LP-DDR PHY 320 may perform an operation (e.g., an operation of transmitting data received through the TSV 330 to volatile memory connected to the processor 110) indicated by the one or more bits received through the pins P21 and P22.

As described above, the signal transmitted from the first SERDES circuitry 131 through the TSV 141 may include one or more bits provided by circuitry of the first circuit layer 130 including the CPU 310. For example, the signal may include a sequence of the one or more bits based on the serialization.

Referring to FIG. 3B, an embodiment in which the data signal and/or the control signal are transmitted from the CPU 310 to the LP-DDR PHY 320 has been described, but the embodiment is not limited thereto. For example, the LP-DDR PHY 320 may transmit data transmitted from the memory to the CPU 310 through the TSV 330. The LP-DDR PHY 320 may transmit a signal for notifying the state of the LP-DDR PHY 320 and/or an interrupt generated in the LP-DDR PHY 320 to the second SERDES circuitry 151 through the pins P21 and P22. The second SERDES circuitry 151 may obtain or generate a signal to be transmitted to the first SERDES circuitry 131 through the TSV 141, by merging the signal with another signal transmitted from other circuitry of the second circuit layer 150 (e.g., serialization). The first SERDES circuitry 131 that received the signal generated by the second SERDES circuitry 151 through the TSV 141 may obtain at least one bit to be transmitted to the CPU 310 through the pins P11 and P12 among the bits included in the signal based on the deserialization.

Referring to FIG. 3C, an exemplary block diagram for describing a plurality of signal paths formed by the TSVs 141, 332, and 334 is illustrated. The first circuit layer 130 (or a first die) including the circuitry such as the CPU 310 and/or the GPU 312 may include the first SERDES circuitry 131 connected to the CPU 310 and the GPU 312. The second circuit layer 150 (or a second die) including the circuitry such as the display controller 322 and/or the ISP 324 may include the second SERDES circuitry 151 connected to the display controller 322 and the ISP 324.

Referring to FIG. 3C, in the first circuit layer 130, the CPU 310 may be connected to the first SERDES circuitry 131 through the signal pins P11 and P12, and the GPU 312 may be connected to the second SERDES circuitry 131 through the signal pins P13 and P14. In the second circuit layer 150, the display controller 322 may be connected to the second SERDES circuitry 151 through the signal pins P21 and P22, and the ISP 324 may be connected to the second SERDES circuitry 151 through the signal pins P23 and P24. Based on the serialization and/or the deserialization (or modulation and/or demodulation) of the first SERDES circuitry 131 and/or the second SERDES circuitry 151, a plurality of signal paths may be integrated in the TSV 141. The plurality of signal paths may include the first signal path between the CPU 310 and the display controller 322, the second signal path between the CPU 310 and the ISP 324, a third signal path between the GPU 312 and the display controller 322, and a fourth signal path between the GPU 312 and the ISP 324. The first signal path may include the signal pins P11 and P21. The second signal path may include the signal pins P12 and P22. The third signal path may include the signal pins P13 and P23. The fourth signal path may include the signal pins P14 and P24.

Referring to FIG. 3C, the interconnect layer 140 may further include other TSVs (e.g., TSVs 332 and 334) for directly connecting the circuitry of the first circuit layer 130 and the circuitry of the second circuit layer 150 as well as the TSV 141 for providing the first signal path to the fourth signal path. For example, the interconnect layer 140 may include the TSV 332 for connecting the CPU 310 and the display controller 322. The interconnect layer 140 may include the TSV 334 for connecting the GPU 312 and the ISP 324. The embodiment is not limited thereto, and a TSV connecting the CPU 310 and the ISP 324 and/or a TSV connecting the GPU 312 and the display controller 322 may be additionally formed in the interconnect layer 140.

In an embodiment, a plurality of sub-circuitry included in the CPU 310 may include the first sub-circuitry (e.g., the first sub-circuitry connected to at least one of the pins P11 and P12) corresponding to the TSV 141 and/or the first SERDES circuitry 131 and/or the second sub-circuitry connected to the TSV 332 to communicate with the display controller 322. The GPU 312 may include third sub-circuitry (e.g., third sub-circuitry connected to at least one of the pins P13 and P14) corresponding to the TSV 141 and/or the first SERDES circuitry 131 and/or fourth sub-circuitry connected to the TSV 334 to communicate with the ISP 324. The display controller 322 may include fifth sub-circuitry (e.g., fifth sub-circuitry connected to the second SERDES circuitry 151 through at least one of the pins P21 and P22) corresponding to the TSV 141 and/or the second SERDES circuitry 151 and/or sixth sub-circuitry connected to the TSV 332 to communicate with the CPU 310. The ISP 324 may include seventh sub-circuitry (e.g., seventh sub-circuitry connected to the second SERDES circuitry 151 through at least one of the pins P23 and P24) corresponding to the TSV 141 and/or the second SERDES circuitry 151 and/or eighth sub-circuitry connected to the TSV 334 to communicate with the GPU 312.

In an embodiment, the first signal path to the fourth signal path may be used to transmit a control signal for controlling the function and/or operation of the circuit, a state signal for notifying the state of the circuit, and/or an interrupt signal for notifying the interrupt. The CPU 310 may transmit the signal in the first type, including the control signal, the state signal, and/or the interrupt signal, to the display controller 322 and/or the ISP 324, through the TSV 141. For example, the CPU 310 may transmit a first signal in the first type related to the display controller 322 to the first SERDES circuitry 131 through the signal pin P11. The CPU 310 may transmit a second signal in the first type related to the ISP 324 to the first SERDES circuitry 131 through the signal pin P12. In the above example, the first SERDES circuitry 131 may generate a third signal to be transmitted to the second SERDES circuitry 151 through the TSV 141 based on the serialization of the first signal and the second signal. The first SERDES circuitry 131 may transmit the third signal to the TSV 141.

In an embodiment in which the third signal is transmitted through the TSV 141, the second SERDES circuitry 151 may obtain the first signal and the second signal based on deserialization with respect to the third signal based on receiving the third signal through the TSV 141. The second SERDES circuitry 151 may transmit the obtained first signal to the display controller 322 through the signal pin P21. The second SERDES circuitry 151 may transmit the obtained second signal to the ISP 324 through the signal terminal P22. Similarly, the GPU 312 may transmit the signal in the first type to the display controller 322 by using the signal pin P13, and may transmit the signal in the second type to the ISP 324 by using the signal pin P14.

In an embodiment, the TSVs 332 and 334 different from the TSV 141 in which the first signal path to third signal path are integrated may be used to transmit data and/or information between circuits. For example, the CPU 310 may transmit information including an image and/or video to be displayed on the display to the display controller 322 through the TSV 332. In the above example, the CPU 310 may transmit, to the display controller 322, a signal in the first type requesting to output the information to the display, by using the TSV 141. The GPU 312 may receive, through the TSV 334, information including an image and/or video (e.g., an image and/or video obtained by a camera) from the ISP 324. In the above example, the GPU 312 may transmit, to the ISP 324, a signal in the first type requesting to transmit the information from the ISP 324, by using the TSV 141.

An embodiment in which the circuitry of the first circuit layer 130 transmits the signal to the circuitry of the second circuit layer 150 has been described, but the embodiment is not limited thereto. For example, the display controller 322 may transmit a signal in the first type for notifying the state of the display controller 322 and/or an interrupt generated by the display controller 322 to the CPU 310 and/or the GPU 312, by using each of the signal pins P21 and P22. Similarly, the ISP 324 may transmit a signal in the first type for notifying the state of the ISP 324 and/or an interrupt generated by the ISP 324 to the CPU 310 and/or the GPU 312, by using the signal pins P23 and P24. Signals received through the signal pins P21 and P22 may be modulated or serialized by the second SERDES circuitry 151. The signals serialized by the second SERDES circuitry 151 may be transmitted to the first SERDES circuitry 131 through the TSV 141. The first SERDES circuitry 131 may obtain or generate signals to be outputted to the CPU 310 and the GPU 312 through each of the signal pins P11, P12, P13, and P14 based on the deserialization of the signal received through the TSV 141.

An embodiment of the processor 110 including the CPU 310, the GPU 312, the display controller 322, and the ISP 324 has been described, but the embodiment is not limited thereto. For example, another circuitry such as the LP-DDR PHY 320 and/or the NPU of the second circuit layer 150 may also be connected to the second SERDES circuitry 151 to use a signal path based on the TSV 141. For example, another circuitry of the first circuit layer 130 different from the CPU 310 and/or the GPU 312 may also be connected to the first SERDES circuitry 131 to use the signal path based on the TSV 141.

As described above with reference to FIGS. 3A to 3C, different circuitry in the processor 110 including the CPU 310 and/or the LP-DDR PHY 320 may use an interface structure formed by the first SERDES circuitry 131, the TSV 141, and the second SERDES circuitry 151. Through the interface structure, information of states of circuitry of the first circuit layer 130 may be transmitted to circuitry of the second circuit layer 150. Through the interface structure, states of circuitry of the second circuit layer 150 may be transmitted and/or broadcast to the circuitry of the first circuit layer 130.

In an embodiment, in order to manage power consumption, states of circuitry in the processor 110 may be adaptively controlled. For example, the CPU 310 may adjust states of the circuitry including states of the CPU 310, based on execution of instructions. For example, a power state of the circuitry may include a sleep state (or a low-voltage state, a low-power state, a disabled or deactivated state) that receives a power signal of a voltage (e.g., a voltage in a range including 0 V) less than a preset voltage. The state of the circuitry may include a wake-up state (or an enabled or activated state) that receives a power signal of a voltage greater than or equal to the preset voltage.

In an embodiment, in order to support transmission of the signal between circuitry independently of the state (e.g., the sleep state and/or the wake-up state) of the CPU 310, the state of the first SERDES circuitry 131 and/or the second SERDES circuitry 151 may be switched or maintained independently of the state of the CPU 310. For example, a power state of at least one of the first SERDES circuitry 131 and the second SERDES circuitry 151 may be controlled independently of a power state of the CPU 310. For example, while the state of the CPU 310 corresponds to the low-power state, the state of the first SERDES circuitry 131 and/or the second SERDES circuitry 151 may maintain the wake-up state. Based on the wake-up state, the first SERDES circuitry 131 and/or the second SERDES circuitry 151 may perform transmission and/or reception of the signal based on the TSV 141. While the state of the CPU 310 corresponds to the low-power state, the first SERDES circuitry 131 and the second SERDES circuitry 151 may perform or control communication based on the TSV 141 independently of the CPU 310.

In an embodiment, the communication based on the TSV 141 may be controlled by the CPU 310 and/or a controller (e.g., controllers 211 and 221) of the SERDES circuit. While the state of the CPU 310 corresponds to the wake-up state, the CPU 310 may control communication in the TSV 141. For example, by the CPU 310 in the wake-up state, a first timing for transmitting the signal from the first SERDES circuitry 131 to the second SERDES circuitry 151 and a second timing for transmitting the signal from the second SERDES circuitry 151 to the first SERDES circuitry 131 may be separated in a time domain. The embodiment is not limited thereto, and any one of the controllers 211 and 221 may operate as a host for controlling the first timing and the second timing. For example, after the CPU 310 switches to the sleep state, any one of the controllers 211 and 221 may operate as the host. In an embodiment, the communication in the TSV 141 may be controlled by the CPU 310 and/or the controllers 211 and 221 operating based on a link training & status state machine (LTSSM).

In an embodiment of periodically transmitting the states of circuitry through the TSV 141, the states of the first SERDES circuitry 131 and the second SERDES circuitry 151 may be periodically switched between the wake-up state and the sleep state. For example, the controllers 211 and 221 may be periodically switched between the wake-up state and the sleep state based on a preset period (e.g., about 5 ms).

As described above, for example, in order to improve a yield of the processor 110, signal paths (e.g., signal paths for transmission of a state and/or an interrupt) for a specific purpose may be integrated into one TSV 141. For example, based on the interface structure based on the TSV 141, the first circuitry 131, and the second circuitry 151, the number of TSVs required to form the signal paths may be reduced. Since the number of TSVs is reduced, difficulty and/or complexity of a process for forming the TSV may be reduced, and the yield of the processor 110 may be improved.

According to an embodiment, the processor 110 may be designed in consideration of a yield of the TSV 141 for connecting the first SERDES circuitry 131 and the second SERDES circuitry 151. Hereinafter, an exemplary structure of the interconnect layer 140 related to a yield of a single TSV 141 formed between the first SERDES circuitry 131 and the second SERDES circuitry 151 is described with reference to FIG. 4.

FIG. 4 illustrates an exemplary structure of an interconnect layer 140 included in a processor 110 according to an embodiment. At least a portion of the processor 110 illustrated in FIG. 4 may correspond to at least a portion of the processor 110 illustrated in FIG. 1, FIG. 2 and/or FIGS. 3A to 3C and features described above in relation to the processor 110 of FIG. 1 FIG. 2 and/or FIGS. 3A to 3C can be included in the processor 110 of FIG. 4, even if not illustrated or specifically described below.

Referring to FIG. 4, a second circuit layer 150, the interconnect layer 140, and a first circuit layer 130 sequentially stacked along a z-axis direction in the processor 110 are illustrated. A TSV 141 based on a serial communication protocol such as a BMC scheme may be formed between first SERDES circuitry 131 and second SERDES circuitry 151. In an embodiment, the processor 110 may include an interface structure robust against a defect in the TSV.

Referring to FIG. 4, the interconnect layer 140 may include at least two TSVs 141 and 410 disposed between the first SERDES circuitry 131 and the second SERDES circuitry 151. The TSVs 141 and 410 may be designed to have substantially the same characteristics (e.g., dimensions, material and/or process filling TSV). In an embodiment in which two TSVs 141 and 410 are formed between the first SERDES circuitry 131 and the second SERDES circuitry 151, the first circuit layer 130 may include a first switching circuit 421 for connecting any one of the TSVs 141 and 410 to the first SERDES circuitry 131. In the above embodiment, the second circuit layer 150 may include a second switching circuit 422 for connecting any one of the TSVs 141 and 410 to the second SERDES circuitry 151. Any one of the TSVs 141 and 410 may be electrically separated from the first SERDES circuitry 131 and the second SERDES circuitry 151 by the first switching circuit 421 and/or the second switching circuit 422.

In an embodiment of FIG. 4, one end of the TSV 141 may be connected to the first SERDES circuitry 131 through the first switching circuit 421, and the other end of the TSV 141 may be connected to the second SERDES circuitry 151 through the second switching circuit 422. Since the TSV 141 is electrically connected to the first SERDES circuitry 131 and the second SERDES circuitry 151 by the first switching circuit 421 and the second switching circuit 422, the TSV 410 may be electrically separated from the first SERDES circuitry 131 and the second SERDES circuitry 151. In the production process of the processor 110, the TSV 410 determined to be defective among the TSVs 141 and 410 may be disconnected from the first SERDES circuitry 131 and the second SERDES circuitry 151.

In an embodiment of FIG. 4, the TSV 141 electrically connected to the first SERDES circuitry 131 and the second SERDES circuitry 151 may be referred to as a main TSV, a normal TSV, and/or a default TSV. In an embodiment of FIG. 4, the TSV 410 electrically disconnected from the first SERDES circuitry 131 and the second SERDES circuitry 151 may be referred to as a sub TSV, a redundant TSV, an auxiliary TSV, and/or an alternative (reserve or substitute) TSV. The embodiment is not limited thereto, and the TSV 410 may be formed in the interconnect layer 140 to establish an electrical connection, based on a defect in the main TSV (e.g., the TSV 141).

In an embodiment, the connection of the TSVs 141 and 410 by the first switching circuit 421 and the second switching circuit 422 may be dynamically changed according to the characteristics of each of the TSVs 141 and 410. For example, in case that the TSV 141 connected to the first SERDES circuitry 131 and the second SERDES circuitry 151 is damaged, instead of the TSV 141, the TSV 410 may be connected to the first SERDES circuitry 131 and the second SERDES circuitry 151. For example, based on a characteristic (e.g., type and/or speed) of a protocol used between the first SERDES circuitry 131 and the second SERDES circuitry 151 and/or a characteristic of a signal transmitted between the first SERDES circuitry 131 and the second SERDES circuitry 151, any one of the TSVs 141 and 410 may be connected to the first SERDES circuitry 131 and the second SERDES circuitry 151. For example, a TSV connected to the first SERDES circuitry 131 and the second SERDES circuitry 151 when transmitting a signal based on the BMC scheme and a TSV connected to the first SERDES circuitry 131 and the second SERDES circuitry 151 when transmitting a signal based on a faster protocol (e.g., MIPI protocol) than the BMC scheme may be different. In the example, any one of the TSVs 141 and 410 may be selected based on different characteristics (e.g., interference characteristics and/or high frequency characteristics) of the TSVs 141 and 410.

The connection between the TSVs 141 and 410 and the SERDES circuitry illustrated above may be controlled by the first switching circuit 421 and the second switching circuit 422. The first switching circuit 421 and/or the second switching circuit 422 may include a controller for controlling the connection. The embodiment is not limited thereto, and the first switching circuit 421 and/or the second switching circuit 422 may be controlled by the controllers 211 and 221 and/or the CPUs (e.g., the CPU 310 of FIG. 3A).

In an embodiment including a plurality of TSVs 141 and 410, the first SERDES circuitry 131 and the second SERDES circuitry 151 may transmit one signal by using all of the plurality of TSVs 141 and 410. For example, a signal transmitted from the first SERDES circuitry 131 may be propagated substantially simultaneously in the plurality of TSVs 141 and 410. The second SERDES circuitry 151 may remove an error occurring in any one of the TSVs 141 and 410 by comparing or combining signals received simultaneously through the TSVs 141 and 410.

In an embodiment including the plurality of TSVs 141 and 410, the first SERDES circuitry 131 and the second SERDES circuitry 151 may use at least one first TSV 141 of the plurality of TSVs 141 and 410 to transmit the signal from the first SERDES circuitry to the second SERDES circuit, and may use a second TSV 410 to transmit the signal from the second SERDES circuitry to the first SERDES circuit. According to an embodiment, transmission and reception of the signal may be performed substantially simultaneously in the TSVs 141 and 410.

As described above, according to an embodiment, the processor 110 may have an interface structure robust to a yield of the TSV and/or an error occurring in the TSV.

In an embodiment, the first SERDES circuitry 131 and the second SERDES circuitry 151 may support communication based on a plurality of protocols including the BMC scheme. Hereinafter, an exemplary structure of the processor 110 including an interface structure supporting communication based on a plurality of protocols will be described with reference to FIG. 5.

FIG. 5 illustrates an exemplary structure of an interconnect layer 140 for supporting a plurality of wired communication protocols. At least a portion of the processor 110 illustrated in FIG. 5 may correspond to at least a portion of the processor 110 illustrated in FIG. 1, FIG. 2 FIGS. 3A to 3C, and/or FIG. 4 and features described above in relation to the processor 110 of FIG. 1 FIG. 2, FIGS. 3A to 3C, and/or FIG. 4 can be included in the processor 110 of FIG. 5, even if not illustrated or specifically described below.

Referring to FIG. 5, at least portions of a second circuit layer 150, the interconnect layer 140, and a first circuit layer 130 sequentially stacked along a z-axis direction in the processor 110 are illustrated. First SERDES circuitry 131 of the first circuit layer 130 may include pins (p11, p12, p13, p14, ... p1k) for connecting with circuitry included in the first integrated circuit layer 130. Second SERDES circuitry 151 of the second circuit layer 150 may include pins (p21, p22, p23, p24, ..., p2k) for connecting with circuitry included in the second circuit layer 150. In order to transmit bits obtained through the above-described pins, one or more TSVs may be formed between the first SERDES circuitry 131 and the second SERDES circuitry 151.

Referring to FIG. 5, in an embodiment including a plurality of TSVs 531, 532, 533, and 534 formed in the interconnect layer 140, transmission of a signal based on a plurality of protocols (e.g., serial communication protocols) may be supported between the first SERDES circuitry 131 and the second SERDES circuitry 151. For example, a high-speed communication protocol (e.g., USB including PCIe, MIPI, and/or USB 3.2) that requires a signal path dedicated for transmission of a clock signal may be supported by a plurality of TSVs 531, 532, 533, and 534, and the first SERDES circuitry 131 and the second SERDES circuitry 151 connected to the plurality of TSVs 531, 532, 533, and 534. Referring to FIG. 5, an interface structure based on four TSVs 531, 532, 533, and 534 is exemplarily illustrated, but the embodiment is not limited thereto.

In an embodiment, the first SERDES circuitry 131 may include circuitry for supporting different high-speed communication protocols. For example, the first SERDES circuitry 131 may include a PCIe circuit 511 for transmitting and/or receiving a PCIe-based signal, a MIPI circuit 512 for transmitting and/or receiving a MIPI-based signal, and a USB circuit 513 for transmitting and/or receiving a USB-based signal. In order to support the high-speed communication protocols, the second SERDES circuitry132 may also include a PCIe circuit 521, a MIPI circuit 522, and a USB circuit 523. The first SERDES circuitry 131 and/or the second SERDES circuitry 151 including circuitry for supporting three high-speed communication protocols (e.g., PCIe, MIPI and/or USB) are exemplarily illustrated, but embodiments are not limited thereto.

In an embodiment, the first SERDES circuitry 131 may include a first multiplexer switching circuit 514 for selecting a protocol. Similarly, the second SERDES circuitry 151 may also include a second multiplexer switching circuit 524 for selecting the protocol. During a first time section transmitting the USB-based signal, in the first SERDES circuitry 131, pins of the USB circuit 513 and the plurality of TSVs 531, 532, 533, and 534 may be connected by the first multiplexer switching circuit 514. During the first time section, in the second SERDES circuitry 151, pins of the USB circuit 523 and the plurality of TSVs 531, 532, 533, and 534 may be connected by the second multiplexer switching circuit 524.

In an embodiment, during a second time section transmitting the PCIe-based signal, in the first SERDES circuitry 131, pins of the PCIe circuit 511 and the plurality of TSVs 531, 532, 533, and 534 may be connected by the first multiplexer switching circuit 514. During the second time section, in the second SERDES circuitry 151, pins of the PCIe circuit 521 and the plurality of TSVs 531, 532, 533, and 534 may be connected by the second multiplexer switching circuit 524. During the second time section, the plurality of TSVs 531, 532, 533, and 534 may match each of signal paths defined by the PCIe.

Similarly, in a third time section transmitting the MIPI-based signal, electrical connections between the MIPI circuitry 512 and 522 based on the plurality of TSVs 531, 532, 533, and 534 may be established by the first multiplexer switching circuit 514 and the second multiplexer switching circuit 524. The protocol corresponding to the signal to be transmitted through the plurality of TSVs 531, 532, 533, and 534 may be determined based on a speed (e.g., data-rate) required for transmission of the signal, a size of information and/or data included in the signal. The determination of the protocol may be performed by a controller (e.g., controllers 211 and 221 of FIG. 2) of the first SERDES circuitry 131 and/or the second SERDES circuitry 151 and/or another circuitry (e.g., a CPU 310 of FIG. 3A) in the processor 110.

As described above, according to an embodiment, the processor 110 may include an interface structure (e.g., an interface structure including the first SERDES circuitry 131, the second SERDES circuitry 151, and the TSV (e.g., the TSVs 531, 532, 533, and 534)) for supporting a plurality of communication protocols. Based on the interface structure, the processor 110 may select a suitable interface protocol.

Hereinafter, an exemplary operation of the processor 110 supporting a single TSV communication based on a BMC scheme will be described with reference to FIG. 6.

FIG. 6 is an exemplary timing diagram 600 for an electrical signal transmitted from an interconnect layer based on a bi-phase mark coding (BMC) scheme. A BMC scheme described with reference to FIG. 6 may be used for transmission of a signal in the interconnect layer (e.g., an interconnect layer 140 of FIGS. 1 to 5) in an interface structure (e.g., an interface structure including first SERDES circuitry 131, second SERDES circuitry 151, and a TSV 141)) included in a processor 110 of FIGS. 1 to 5.

In an embodiment, first SERDES circuitry of a first circuit layer (e.g., a first circuit layer 130 of FIGS. 1 to 5) may encode a signal obtained based on serialization, based on the BMC scheme. The first SERDES circuitry may transmit the encoded signal to the second SERDES circuitry of a second circuit layer (e.g., a second circuit layer 150 of FIGS. 1 to 5) through the TSV.

In an embodiment, the BMC scheme may be used for communication (e.g., 1-wire power delivery (PD) communication) at a Configuration Channe (CC) pin of USB Type-C. The BMC scheme may be referred to as a differential manchester encoding scheme. At the CC pin, ID and/or power profile information may be transmitted or received based on the BMC scheme. Referring to FIG. 6, the exemplary timing diagram 600 related to an electrical signal transmitted through the TSV (e.g., the TSV 141 of FIGS. 1 to 4) of the interconnect layer is illustrated based on the BMC scheme.

Referring to FIG. 6, in the timing diagram 600, graphs 610, 620, and 630 are illustrated along an equivalent time domain. The graph 610 illustrates a clock signal related to the electrical signal to be transmitted through the TSV. The graph 620 illustrates a plurality of bits to be included in the electrical signal to be transmitted through the TSV. The plurality of bits may be serialized by a SERDES circuit. For example, the plurality of bits may be provided from different circuitry connected to the SERDES circuitry in order to notify a state and/or an interrupt. Referring to the graph 620 of FIG. 6, in an embodiment of transmitting starting from a most significant bit (MSB) in a sequence of serialized bits, the sequence of the bits serialized by the SERDES circuitry may include 10011010010₍₂₎. The graph 630 may indicate a final sequence of bits included in a signal transmitted to the TSV by the SERDES circuit.

According to an embodiment, the SERDES circuitry may transmit all of the clock signal and data (e.g., the sequence of bits) through a single signal path (e.g., the TSV 141 of FIGS. 1 to 4) based on the BMC scheme. Based on the BMC scheme, in each of a rising edge and a falling edge of the clock signal indicated by the graph 610, bits to be included in the final sequence may be determined or changed based on the bits indicated by the graph 620. Based on the BMC scheme, a voltage level of the signal transmitted to the TSV may be changed in a time section (e.g., t1, t4, t5, t7, and/or t10) encoding the bit 1 in the sequence. In a visual guide (e.g., t2, t3, t6, t8, and/or t9) encoding the bit 0 in the sequence, the voltage level of the signal transmitted to the TSV may be maintained.

In an embodiment, the SERDES circuitry that received a signal of the voltage level such as the graph 630 through the TSV may obtain a sequence of the clock and bits from the signal based on the characteristics of the BMC scheme. For example, in time sections (t1, t4, t5, t7, and/or t10) in which the voltage level changes, the SERDES circuitry may determine that bit 1 is encoded. For example, in time sections (t2, t3, t6, t8, and/or t9) in which the voltage level is maintained, the SERDES determine that the bit 0 has been received. From the signal based on the graph 630, the SERDES circuitry that identified the sequence of bits indicated by the graph 620 may obtain a bit to be outputted to each of the plurality of pins of the SERDES circuit, by dividing the bits, based on deserialization.

An exemplary operation of the SERDES circuitry for analyzing a signal transmitted through a single TSV based on the BMC scheme has been described, but the embodiment is not limited thereto. As described above with reference to FIGS. 1 to 5, the SERDES circuitry may transmit or analyze a signal based on a protocol having a data-rate exceeding the data-rate supported by the BMC scheme, such as I2C, I3C, USB (e.g., USB 3.2), PCIe, MIPI (D-PHY, C-PHY, M-PHY), DP (display port), LPDDR4-6, and/or UFS. In order to support high-speed protocols, a plurality of TSVs may be formed between SERDES circuitry disposed in different circuit layers.

As described above, an electronic device including an AP having a structure in which a plurality of circuit layers are stacked is provided. In the AP, an interconnect layer including a signal path (e.g., a signal path based on the TSV) between the plurality of circuit layers may be formed. In order to reduce the number of TSVs included in the interconnect layer, an integrated signal transmission interface based on SERDES circuitry may be formed in each of the circuit layers disposed above and below the interconnect layer. Each of the SERDES circuitry may perform serialization of the bits (e.g., bits indicating a numeric value to notify the states and/or interrupts of the circuits) of the circuitry included in the corresponding circuit layer. The signal based on the serialization may be transmitted from a specific circuit layer to another circuit layer through at least one TSV of the interconnect layer. In response to a signal received through the TSV, each of the SERDES circuitry may perform deserialization of bits included in the signal. Signals and/or bits obtained based on the deserialization may be allocated to other circuitry connected to the SERDES circuitry that performed the deserialization.

Hereinafter, an embodiment of the AP and/or the electronic device described with reference to FIGS. 1 to 6 will be described with reference to FIG. 7.

FIG. 7 is a block diagram illustrating an electronic device 701 in a network environment 700 according to various embodiments. Referring to FIG. 7, the electronic device 701 in the network environment 700 may communicate with an electronic device 702 via a first network 798 (e.g., a short-range wireless communication network), or at least one of an electronic device 704 or a server 708 via a second network 799 (e.g., a long-range wireless communication network). According to an embodiment, the electronic device 701 may communicate with the electronic device 704 via the server 708. According to an embodiment, the electronic device 701 may include a processor 720, memory 730, an input module 750, a sound output module 755, a display module 760, an audio module 770, a sensor module 776, an interface 777, a connecting terminal 778, a haptic module 779, a camera module 780, a power management module 788, a battery 789, a communication module 790, a subscriber identification module(SIM) 796, or an antenna module 797. In some embodiments, at least one of the components (e.g., the connecting terminal 778) may be omitted from the electronic device 701, or one or more other components may be added in the electronic device 701. In some embodiments, some of the components (e.g., the sensor module 776, the camera module 780, or the antenna module 797) may be implemented as a single component (e.g., the display module 760).

The processor 720 may execute, for example, software (e.g., a program 740) to control at least one other component (e.g., a hardware or software component) of the electronic device 701 coupled with the processor 720, and may perform various data processing or computation. According to an embodiment, as at least part of the data processing or computation, the processor 720 may store a command or data received from another component (e.g., the sensor module 776 or the communication module 790) in volatile memory 732, process the command or the data stored in the volatile memory 732, and store resulting data in non-volatile memory 734. According to an embodiment, the processor 720 may include a main processor 721 (e.g., a central processing unit (CPU) or an application processor (AP)), or an auxiliary processor 723 (e.g., a graphics processing unit (GPU), a neural processing unit (NPU), an image signal processor (ISP), a sensor hub processor, or a communication processor (CP)) that is operable independently from, or in conjunction with, the main processor 721. For example, when the electronic device 701 includes the main processor 721 and the auxiliary processor 723, the auxiliary processor 723 may be adapted to consume less power than the main processor 721, or to be specific to a specified function. The auxiliary processor 723 may be implemented as separate from, or as part of the main processor 721.

The auxiliary processor 723 may control at least some of functions or states related to at least one component (e.g., the display module 760, the sensor module 776, or the communication module 790) among the components of the electronic device 701, instead of the main processor 721 while the main processor 721 is in an inactive (e.g., sleep) state, or together with the main processor 721 while the main processor 721 is in an active state (e.g., executing an application). According to an embodiment, the auxiliary processor 723 (e.g., an image signal processor or a communication processor) may be implemented as part of another component (e.g., the camera module 780 or the communication module 790) functionally related to the auxiliary processor 723. According to an embodiment, the auxiliary processor 723 (e.g., the neural processing unit) may include a hardware structure specified for artificial intelligence model processing. An artificial intelligence model may be generated by machine learning. Such learning may be performed, e.g., by the electronic device 701 where the artificial intelligence is performed or via a separate server (e.g., the server 708). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 730 may store various data used by at least one component (e.g., the processor 720 or the sensor module 776) of the electronic device 701. The various data may include, for example, software (e.g., the program 740) and input data or output data for a command related thereto. The memory 730 may include the volatile memory 732 or the non-volatile memory 734.

The program 740 may be stored in the memory 730 as software, and may include, for example, an operating system (OS) 742, middleware 744, or an application 746.

The input module 750 may receive a command or data to be used by another component (e.g., the processor 720) of the electronic device 701, from the outside (e.g., a user) of the electronic device 701. The input module 750 may include, for example, a microphone, a mouse, a keyboard, a key (e.g., a button), or a digital pen (e.g., a stylus pen).

The sound output module 755 may output sound signals to the outside of the electronic device 701. The sound output module 755 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 760 may visually provide information to the outside (e.g., a user) of the electronic device 701. The display module 760 may include, for example, a display, a hologram device, or a projector and control circuitry to control a corresponding one of the display, hologram device, and projector. According to an embodiment, the display module 760 may include a touch sensor adapted to detect a touch, or a pressure sensor adapted to measure the intensity of force incurred by the touch.

The audio module 770 may convert a sound into an electrical signal and vice versa. According to an embodiment, the audio module 770 may obtain the sound via the input module 750, or output the sound via the sound output module 755 or a headphone of an external electronic device (e.g., an electronic device 702) directly (e.g., wiredly) or wirelessly coupled with the electronic device 701.

The sensor module 776 may detect an operational state (e.g., power or temperature) of the electronic device 701 or an environmental state (e.g., a state of a user) external to the electronic device 701, and then generate an electrical signal or data value corresponding to the detected state. According to an embodiment, the sensor module 776 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 777 may support one or more specified protocols to be used for the electronic device 701 to be coupled with the external electronic device (e.g., the electronic device 702) directly (e.g., wiredly) or wirelessly. According to an embodiment, the interface 777 may include, for example, a high definition multimedia interface (HDMI), a universal serial bus (USB) interface, a secure digital (SD) card interface, or an audio interface.

A connecting terminal 778 may include a connector via which the electronic device 701 may be physically connected with the external electronic device (e.g., the electronic device 702). According to an embodiment, the connecting terminal 778 may include, for example, an HDMI connector, a USB connector, a SD card connector, or an audio connector (e.g., a headphone connector).

The haptic module 779 may convert an electrical signal into a mechanical stimulus (e.g., a vibration or a movement) or electrical stimulus which may be recognized by a user via his tactile sensation or kinesthetic sensation. According to an embodiment, the haptic module 779 may include, for example, a motor, a piezoelectric element, or an electric stimulator.

The camera module 780 may capture a still image or moving images. According to an embodiment, the camera module 780 may include one or more lenses, image sensors, image signal processors, or flashes.

The power management module 788 may manage power supplied to the electronic device 701. According to an embodiment, the power management module 788 may be implemented as at least part of, for example, a power management integrated circuit (PMIC).

The battery 789 may supply power to at least one component of the electronic device 701. According to an embodiment, the battery 789 may include, for example, a primary cell which is not rechargeable, a secondary cell which is rechargeable, or a fuel cell.

The communication module 790 may support establishing a direct (e.g., wired) communication channel or a wireless communication channel between the electronic device 701 and the external electronic device (e.g., the electronic device 702, the electronic device 704, or the server 708) and performing communication via the established communication channel. The communication module 790 may include one or more communication processors that are operable independently from the processor 720 (e.g., the application processor (AP)) and supports a direct (e.g., wired) communication or a wireless communication. According to an embodiment, the communication module 790 may include a wireless communication module 792 (e.g., a cellular communication module, a short-range wireless communication module, or a global navigation satellite system (GNSS) communication module) or a wired communication module 794 (e.g., a local area network (LAN) communication module or a power line communication (PLC) module). A corresponding one of these communication modules may communicate with the external electronic device via the first network 798 (e.g., a short-range communication network, such as Bluetooth^{™}, wireless-fidelity (Wi-Fi) direct, or infrared data association (IrDA)) or the second network 799 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 792 may identify and authenticate the electronic device 701 in a communication network, such as the first network 798 or the second network 799, using subscriber information (e.g., international mobile subscriber identity (IMSI)) stored in the subscriber identification module 796.

The wireless communication module 792 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 792 may support a high-frequency band (e.g., the mmWave band) to achieve, e.g., a high data transmission rate. The wireless communication module 792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 792 may support various requirements specified in the electronic device 701, an external electronic device (e.g., the electronic device 704), or a network system (e.g., the second network 799). According to an embodiment, the wireless communication module 792 may support a peak data rate (e.g., 20Gbps or more) for implementing eMBB, loss coverage (e.g., 764dB or less) for implementing mMTC, or U-plane latency (e.g., 0.5ms or less for each of downlink (DL) and uplink (UL), or a round trip of 7ms or less) for implementing URLLC.

The antenna module 797 may transmit or receive a signal or power to or from the outside (e.g., the external electronic device) of the electronic device 701. According to an embodiment, the antenna module 797 may include an antenna including a radiating element composed of a conductive material or a conductive pattern formed in or on a substrate (e.g., a printed circuit board (PCB)). According to an embodiment, the antenna module 797 may include a plurality of antennas (e.g., array antennas). In such a case, at least one antenna appropriate for a communication scheme used in the communication network, such as the first network 798 or the second network 799, may be selected, for example, by the communication module 790 (e.g., the wireless communication module 792) from the plurality of antennas. The signal or the power may then be transmitted or received between the communication module 790 and the external electronic device via the selected at least one antenna. According to an embodiment, another component (e.g., a radio frequency integrated circuit (RFIC)) other than the radiating element may be additionally formed as part of the antenna module 797.

According to various embodiments, the antenna module 797 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 701 and the external electronic device 704 via the server 708 coupled with the second network 799. Each of the electronic devices 702 or 704 may be a device of a same type as, or a different type, from the electronic device 701. According to an embodiment, all or some of operations to be executed at the electronic device 701 may be executed at one or more of the external electronic devices 702, 704, or 708. For example, if the electronic device 701 should perform a function or a service automatically, or in response to a request from a user or another device, the electronic device 701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 701. The electronic device 701 may provide the outcome, with or without further processing of the outcome, as at least part of a reply to the request. To that end, a cloud computing, distributed computing, mobile edge computing (MEC), or client-server computing technology may be used, for example. The electronic device 701 may provide ultra low-latency services using, e.g., distributed computing or mobile edge computing. In another embodiment, the external electronic device 704 may include an internet-of-things (IoT) device. The server 708 may be an intelligent server using machine learning and/or a neural network. According to an embodiment, the external electronic device 704 or the server 708 may be included in the second network 799. The electronic device 701 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 740) including one or more instructions that are stored in a storage medium (e.g., internal memory 736 or external memory 738) that is readable by a machine (e.g., the electronic device 701). For example, a processor (e.g., the processor 720) of the machine (e.g., the electronic device 701) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In an embodiment, a method of integrating signal paths established in the AP may be required. In an embodiment, a method of increasing a yield of the AP included in the electronic device may be required. In an embodiment, a method for stably producing the AP including stacked circuit layers may be required. As mentioned above, according to an embodiment, a three-dimension integrated circuit (3D-IC) (e.g., a processor 110 of FIG. 1) may include a substrate, a first integrated circuit layer (e.g., a second circuit layer 150 of FIG. 1) disposed over the substrate and including a plurality of first circuit elements, a second integrated circuit layer (e.g., first circuit layer 130 of FIG. 1) disposed over the first integrated circuit layer and including a plurality of second circuit elements, and an interconnect layer (e.g., an interconnect layer 140 of FIG. 1) disposed between the first integrated circuit layer and the second integrated circuit layer and including a plurality of through silicon via (TSVs) (e.g., TSVs 141 and 142 of FIG. 1). The plurality of first circuit elements may include a plurality of first signal pins corresponding to a first signal type and at least one second signal pin corresponding to a second signal type. The plurality of first signal pins may be connected to a first TSV (e.g., a TSV 141 of FIG. 1) among the plurality of TSVs through a first serializer-deserializer (SERDES) circuit (e.g., second SERDES circuitry 151 of FIG. 1). The plurality of second circuit elements may include a plurality of third signal pins corresponding to the plurality of first signal pins and at least one fourth signal pin corresponding to the at least one second signal pin. The first TSV may be connected to the plurality of third signal pins through second SERDES circuitry (e.g., first SERDES circuitry 131 of FIG. 1). In an embodiment, signal paths established in the AP may be integrated. In an embodiment, the yield of the AP included in the electronic device may be increased. In an embodiment, the AP including stacked circuit layers may be stably produced.

For example, the plurality of TSVs may include a substitute TSV (e.g., a TSV 410 of FIG. 4) that connects between the first SERDES circuitry and the second SERDES circuitry and is configured to have characteristics of the first TSV.

For example, the substitute TSV may be configured to operate based on a connection state based on the first TSV.

For example, the first signal type may correspond to a control signal, and the second signal type may correspond to a data signal.

For example, the first TSV and the substitute TSV may be connected to the first SERDES circuitry through a first switching circuit (e.g., a second switching circuit 422 of FIG. 4). The first TSV and the substitute TSV may be configured to be connected to the second SERDES circuitry through a second switching circuit (e.g., a first switching circuit 421 of FIG. 4).

For example, the at least one first data signal pin and the at least one second data signal pin may be configured to be directly connected through a second TSV among the plurality of TSVs.

For example, the plurality of first signal pins may be configured to include a signal pin related to an interrupt and a signal pin related to a reset.

For example, a plurality of control signals corresponding to the plurality of first signal pins may be generated at different timings. The first SERDES circuitry may be configured to transmit the plurality of control signals to the second SERDES circuitry based on a specified period.

For example, the plurality of first circuit elements may be configured to include a modem. The plurality of second circuit elements may be configured to include a central processing unit (CPU) (e.g., a CPU 310 of FIGS. 3A to 3C).

For example, the minimum line width of the first integrated circuit layer may be greater than the minimum line width of the second integrated circuit layer.

For example, the first SERDES circuitry and the second SERDES circuitry may be configured to communicate by using serial communication of 5 mbps or less through the first TSV.

For example, the first SERDES circuitry and the second SERDES circuitry may be configured to communicate based on a specified serial communication protocol for each of the plurality of first signals among a plurality of serial communication protocols.

For example, the first TSV may be configured to be selected based on the specified serial communication protocol from among the plurality of TSVs.

For example, the first SERDES circuitry may be configured to maintain a wake-up state while a low-voltage power signal is supplied to the first circuit elements.

For example, the first SERDES circuitry may include a controller (e.g., a controller 211 of FIG. 2). The controller may be configured to control communication between the first SERDES circuitry and the second SERDES circuitry based on whether the first circuit elements receive the power signal of the low voltage.

As described above, according to an embodiment, an electronic device (e.g., an electronic device 101 of FIG. 1) may comprise a display (e.g., a display 123 of FIG. 1), an antenna, a printed circuit board (e.g., a PCB 105 of FIG. 1), a first integrated circuit disposed on the printed circuit board, and a second integrated circuit disposed on the printed circuit board and electrically connected to the first integrated circuit. The second integrated circuit may comprise a first circuit layer comprising a plurality of first circuit elements, a second circuit layer disposed over the first circuit layer and comprising a plurality of second circuit elements, and an interconnect layer disposed between the first circuit layer and the second circuit layer and comprising a plurality of through silicon vias (TSVs). The plurality of first circuit elements may include a plurality of first signal pins corresponding to a first signal type and at least one second signal pin corresponding to a second signal type. The plurality of first control signal pins may be connected to the first TSV among the plurality of TSVs through a first serializer-deserializer (SERDES) circuit. The plurality of second circuit elements may include a plurality of third control signal pins corresponding to the plurality of first control signal pins and at least one fourth signal pin corresponding to the at least one second signal pin. The first TSV may be connected to the plurality of third control signal pins through the second SERDES circuit.

For example, the plurality of TSVs may include a second TSV that connects between the first SERDES circuitry and the second SERDES circuitry and transmits substantially the same signal as the first TSV.

For example, the at least one second signal pin and the at least one fourth signal pin may be directly connected through a third TSV among the plurality of TSVs.

As described above, according to an embodiment, an integrated circuit may include a first integrated circuit layer including a plurality of first circuit elements corresponding to a first minimum circuit line width, a second integrated circuit layer disposed over the first integrated circuit layer and including a plurality of second circuit elements corresponding to a second minimum circuit line width smaller than the first minimum circuit line width, and a plurality of vias electrically connecting the first integrated circuit layer and the second integrated circuit layer. The first integrated circuit layer may include a first serializer-deserializer (SERDES) circuit that connects the plurality of first circuit elements to a first via that is some of the plurality of vias. The second integrated circuit layer may include second SERDES circuitry connecting the first via to the plurality of second circuit elements.

For example, the plurality of first circuit elements may include a plurality of control signal pins. A plurality of control signals corresponding to the plurality of control signal pins may be configured to be transmitted through the first via based on a serial communication protocol.

For example, the integrated circuit may include a second via configured to transmit substantially the same signal as the first via. The second via may be configured to be disposed between the first SERDES circuitry and the second SERDES circuit.

As described above, according to an embodiment, an application processor (AP) (e.g., a processor 110 of FIGS. 1 to 5) may comprise a first circuit layer (e.g., a first circuit layer 130 of FIG. 1) including a first serializer-deserializer (SERDES) electronic component (e.g., first SERDES circuitry 131 of FIG. 1)connected to each of a first electronic component (e.g., circuitry 132 of FIG. 1), at least one second electronic component, and third electronic components including the first electronic component and the at least one second electronic component, a second circuit layer (e.g., a second circuit layer 150 of FIG. 1) including a fourth electronic component (e.g., second circuitry 152 of FIG. 1) and a second SERDES electronic component (e.g., second SERDES circuitry 151 of FIG. 1) connected to the fourth electronic component, and an interconnect layer (e.g., an interconnect layer 140 of FIG. 1) disposed between the first circuit layer and the second circuit layer. The interconnect layer may include TSVs including a first through silicon via (TSV) (e.g., a TSV 142 of FIG. 1) connecting the first electronic component to the fourth electronic component and a second TSV (e.g., a TSV 141 of FIG. 1) connecting the first SERDES electronic component to the second SERDES electronic component. The first electronic component may transmit a signal in a first type to the fourth electronic component through the first TSV in the interconnect layer. The first electronic component may transmit a signal in a second type to the first SERDES electronic component in order to transmit the signal in the second type to the fourth electronic component. The first SERDES electronic component may perform serialization of the signal of the second type together with at least one signal transmitted from the at least one second electronic component. The first SERDES electronic component may transmit a signal obtained based on the serialization to the second SERDES electronic component through the second TSV. The second SERDES electronic component may be configured to obtain the signal in the second type to be transmitted to the fourth electronic component based on deserialization of the signal transmitted through the second TSV.

For example, the first SERDES electronic component may include a buffer (e.g., a buffer 212 of FIG. 2) configured to store one or more bits indicating the state of the first electronic component included in the signal in the second type.

For example, the first SERDES electronic component may be configured to generate a sequence of a plurality of bits, by performing serialization of the one or more bits and at least one bit included in the at least one signal transmitted from the at least one second electronic component. The first SERDES electronic component may be configured to transmit the signal including the sequence to the second SERDES electronic component through the second TSV.

For example, the first SERDES electronic component may be configured to store at least one bit obtained from the third electronic components in the buffer in a preset time section. The first SERDES electronic component may be configured to perform serialization of the at least one bit stored in the buffer based on expiration of the preset time section.

For example, the second SERDES electronic component may be configured to generate a signal to be transmitted to the first SERDES electronic component through the second TSV based on the signal in the second type transmitted from the fourth electronic component.

For example, the second SERDES electronic component may be connected to each of fifth electronic components including the fourth electronic component included in the second circuit layer. The second SERDES electronic component may be configured to generate the signal to be transmitted to the first SERDES electronic component based on serialization of the signal in the second type transmitted from the fifth electronic components.

For example, the second SERDES electronic component may be configured to receive, from the fourth electronic component, the signal of the second type for notifying at least one of a state of the fourth electronic component or an interrupt related to the fourth electronic component to the first electronic component, which is the central processing unit (CPU) (e.g., the CPU 310 of FIGS. 3A to 3C).

For example, the second SERDES electronic component may be configured to transmit the plurality of bits to each of the fifth electronic components on the second circuit layer including the fourth electronic component, based on a digit of each of the plurality of bits in the signal transmitted through the second TSV, based on the deserialization.

For example, the first circuit layer may be configured to include a circuit element having a size smaller than the minimum size of circuit elements included in the second circuit layer.

For example, the first SERDES electronic component may be configured to transmit the signal obtained based on the serialization and encoded based on a bi-phase mark coding (BMC) scheme, to the second SERDES electronic component through the second TSV.

For example, the second TSV may be configured to transmit the signal in a first data-rate range including 300 kbps. The first TSV may be configured to transmit the signal in the first type in a second data-rate range exceeding the first data-rate range.

For example, the interconnect layer may be configured to include a third TSV (e.g., a TSV 410 of FIG. 4), among the second TSV or the third TSV, a first switching electronic component (e.g., the first switching circuit 421 of FIG. 4 ) configured to connect an end of the second TSV to the first SERDES electronic component, and among the second TSV or the third TSV, a second switching electronic component (e.g., the second switching circuit 422 of FIG. 4) configured to connect the other end of the second TSV to the second SERDES electronic component.

For example, the first electronic component may be configured to transmit the signal in the first type including data to the fourth electronic component through the first TSV. The first electronic component may be configured to transmit the signal in the second type for controlling a controller included in the fourth electronic component to the first SERDES electronic component.

For example, the fourth electronic component may be configured to transmit the data to volatile memory connected to the application processor based on the signal in the first type.

For example, the controller of the fourth electronic component may be configured to receive the signal in the second type based on general purpose input output (GPIO).

As described above, according to an embodiment, an application processor (AP) may comprise a first circuit layer including a first electronic component, a plurality of second electronic components including the first electronic component, and a first serializer-deserializer (SERDES) electronic component connected to each of the plurality of second electronic components, a second circuit layer including a third electronic component and a second SERDES electronic component connected to the third electronic component, and an interconnect layer disposed between the first circuit layer and the second circuit layer. The interconnect layer may include a first through silicon via (TSV), configured to directly connect the first electronic component to the third electronic component, and configured to transmit a signal in a first type from the first electronic component to the third electronic component. The interconnect layer may include a second TSV configured to connect the first SERDES electronic component to the second SERDES electronic component and configured to transmit a signal in a second type based on serialization of the first SERDES electronic component. The signal in the second type transmitted through the second TSV may include a sequence of bits of the plurality of second electronic components based on the serialization, including at least one bit provided by the first electronic component.

For example, the first SERDES electronic component may include a buffer configured to store bits transmitted from each of the plurality of second electronic components. The first SERDES electronic component may be configured to obtain a plurality of bits to be included in the signal of the second type to be transmitted to the second SERDES electronic component through the second TSV, based on the serialization of the bits stored in the buffer during a preset time section.

For example, the first SERDES electronic component may be configured to obtain at least one bit to be provided to each of the plurality of second electronic components, by performing deserialization of the received signal in the second type, in response to receiving the signal in the second type from the second SERDES electronic component through the second TSV.

For example, the first electronic component, which is the central processing unit (CPU), may be configured to transmit the signal in the first type including data to the third electronic component through the first TSV. The first electronic component may be configured to transmit the signal in the second type for controlling a controller of the third electronic component to the first SERDES electronic component.

As described above, according to an embodiment, an electronic device may include a memory and an application processor (AP). The AP may include a first circuit layer including a plurality of electronic components including a central processing unit (CPU) and a first serializer-deserializer (SERDES) electronic component connected to each of the plurality of electronic components, a second circuit layer including a memory interface electronic component and a second SERDES electronic component for communicating with the memory, an interconnect layer disposed between the first circuit layer and the second circuit layer. The interconnect layer may include a first through silicon via (TSV) configured to directly connect the CPU of the first circuit layer and the memory interface electronic component. The interconnect layer may include a second TSV configured to connect the first SERDES electronic component and the second SERDES electronic component. The CPU may be configured to transmit a data signal including data to be stored in the memory to the memory interface electronic component through the first TSV. The CPU, which is the first SERDES electronic component, may be configured to transmit a control signal for controlling the memory interface electronic component so that the data is transmitted to the memory.

For example, the first SERDES electronic component may be configured to obtain a signal including a sequence of bits included in control signals, by performing serialization of the control signals obtained from the plurality of electronic components. The first SERDES electronic component may be configured to transmit the signal including the sequence to the second SERDES electronic component through the second TSV.

For example, the first SERDES electronic component may be configured to transmit the signal including the sequence based on a bi-phase mark coding (BMC) scheme.

For example, the first SERDES electronic component may be configured to, based on receiving a signal transmitted from the second SERDES electronic component through the second TSV, obtain at least one bit to be transmitted to the CPU, based on deserialization of the bits included in the received signal.

For example, the data signal may be configured to be transmitted based on the first data-rate exceeding the second data-rate supported by the second TSV, in the first TSV.

For example, the plurality of electronic components may be configured to include a circuit element having a size smaller than the minimum size of circuit elements included in the memory interface electronic component of the second circuit layer.

As described above, according to an embodiment, a processing chip component may comprise a first die including first circuitry, second circuitry, and first serializer-deserializer (SERDES) circuitry connected to the first circuitry and the second circuitry. The processing chip component may comprise a second die including third circuitry, fourth circuitry and second SERDES circuitry connected to the third circuitry and the fourth circuitry. The processing chip component may comprise an interconnect layer disposed between the first die and the second die. The interconnect layer may include a first through silicon via (TSV) configured to be connected between the first SERDES circuitry and the second SERDES circuitry and to provide a first signal path between the first circuitry and the third circuitry, a second signal path between the first circuitry and the fourth circuitry, a third signal path between the second circuitry and the third circuitry, and a fourth signal path between the second circuitry and the fourth circuitry.

For example, the interconnect layer may include a second TSV connecting the first circuitry to the third circuitry. The first circuitry may be configured to transmit a signal in a first type to the third circuitry through the second TSV in the interconnect layer. The first circuitry may be configured to transmit a signal in a second type to the first SERDES circuitry to transmit the signal in the second type to the third circuitry. The first SERDES circuitry may be configured to perform serialization of the signal in the second type with a signal transmitted from the second circuitry. The first SERDES circuitry may be configured to transmit a signal obtained based on the serialization to the second SERDES circuitry through the first TSV. The second SERDES circuitry may be configured to obtain the signal in the second type to be transmitted to the third circuitry based on deserialization of the signal transmitted through the first TSV.

For example, the signal in the first type may comprise a data signal to be inputted to the third circuitry. The signal in the second type may comprise a control signal corresponding to the third circuitry.

For example, the first SERDES circuitry may comprise a buffer for storing bits received from the first circuitry and the second circuitry, wherein the bits are corresponding to each of the first signal path, the second signal path, the third signal path and the fourth signal path. The first SERDES circuitry may comprise a controller configured to generate a sequence of bits to be included in a signal to be transmitted to the second die through the first TSV by performing serialization with respect to the bits stored in the buffer.

For example, the first SERDES circuitry may be configured to store the bits which are obtained from the first circuitry and the second circuitry in a preset time section, into the buffer. The first SERDES circuitry may be configured to perform the serialization of the bits stored in the buffer based on expiration of the preset time section.

For example, the first circuitry may be corresponding to a central processing unit (CPU) circuitry, and the second circuitry may be corresponding to a graphic processing unit (GPU) circuitry.

For example, the third circuitry may be corresponding to an image signal processor (ISP) circuitry. The fourth circuitry may be corresponding to a display controlling circuitry.

For example, the interconnect layer may comprise a second TSV connected to a second signal pin of the CPU circuitry, wherein the CPU circuitry includes a first signal pin connected to the first SERDES circuitry. The ISP circuitry may comprise a third signal pin which is electrically connected to the second TSV.

For example, the CPU circuitry may be configured to transmit a control signal to request data from the ISP circuitry, to the first SERDES circuitry through the first signal pin. The CPU circuitry may be configured to receive, through the second signal pin connected to the second TSV, the data corresponding to the control signal from the ISP circuitry.

For example, the third circuitry may be corresponding to a memory interface circuitry to communicate with memory connected to the processing chip component. The fourth circuitry may be corresponding to a neural processing unit (NPU) circuitry.

For example, the second SERDES circuitry may be configured to generate a signal to be transmitted to the first SERDES circuitry through the first TSV based on serialization of signals transmitted from the third circuitry and the fourth circuitry.

For example, the second SERDES circuitry may be configured to receive, from the third circuitry, the signal for notifying, to first circuitry that is a central processing unit (CPU), at least one of a state of the third circuitry or interruption associated with the third circuitry.

For example, the second SERDES electronic component may be configured to obtain at least one bit corresponding to each of the first signal path, the second signal path, the third signal path and the fourth signal path based on digit of each of a plurality of bits in a signal transmitted through the first TSV based on deserialization.

For example, the first die may be configured to comprise a circuit element having a size smaller than minimum size of circuit elements included in the second die.

For example, the first SERDES circuitry may be configured to transmit the signal that is obtained based on the serialization and encoded based on bi-phase mark coding (BMC) scheme, to the second SERDES circuitry through the first TSV.

For example, the first TSV may be configured to transmit a signal in a first data-rate range including 300 kbps. The interconnect layer may comprise a second TSV configured to transmit a signal in a second data-rate range exceeding the first data-rate range.

For example, the interconnect layer may comprise a redundant TSV. The interconnect layer may comprise a first switching circuitry configured to connect an end of the first TSV, among the first TSV or the redundant TSV, to the first SERDES circuitry. The interconnect layer may be configured to comprise a second switching circuitry configured to connect another end of the first TSV, among the first TSV or the redundant TSV, to the second SERDES circuitry.

For example, the first circuitry may be configured to transmit a signal of a first type including data, to the third circuitry through a second TSV included in the interconnect layer. The first circuitry may be configured to transmit, to transmit a signal of a second type for controlling a controller included in the third circuitry through the third signal path, the signal of the second type to the first SERDES circuitry.

For example, the first SERDES circuitry may be configured to transmit a signal based on a general purpose input output (GPIO) to the second SERDES circuitry through the first TSV.

As described above, according to an embodiment, a processing chip component may comprise a first die including first circuitry and second circuitry, and first SERDES circuitry connected to the first circuitry and the second circuitry. The processing chip component may comprise a second die including third circuitry and fourth circuitry, and second SERDES circuitry connected to the third circuitry and the fourth circuitry. The processing chip component may comprise an interconnect layer disposed between the first die and the second die. The interconnect layer may comprise a first through silicon via (TSV) configured to directly connect the first circuitry to the third circuitry and configured to transmit a signal in a first type to the third circuitry from the first circuitry. The interconnect layer may comprise a second TSV configured to connect the first SERDES circuitry to the second SERDES circuitry and configured to transmit a signal in a second type based on serialization of the first SERDES circuitry. The signal in the second type transmitted through the second TSV may comprise a sequence of at least one bit provided by the first circuitry and at least one bit provided by the second circuitry.

As described above, according to an embodiment, an electronic device may comprise a memory and a processor. The processor may comprise a first die comprising a plurality of circuitry including a central processing unit (CPU) and a first serializer-deserializer (SERDES) circuitry coupled to each of the plurality of circuits. The processor may comprise a second die comprising a memory interface circuitry to communicate with the memory and second SERDES circuitry. The processor may comprise an interconnect layer disposed between the first die and the second die. The interconnect layer may comprise a first through silicon via (TSV) configured to directly connect the CPU of the first die to the memory interface circuitry. The interconnect layer may comprise a second TSV configured to connect the first SERDES circuitry to the second SERDES circuitry. The CPU may be configured to transmit a data signal including data to be stored in the memory to the memory interface circuitry through the first TSV. The CPU may be configured to transmit a control signal for controlling the memory interface circuitry to the first SERDES circuitry such that the data is transmitted to the memory.

In a first example, there is provided a processing chip component comprising: a first die including first circuitry, second circuitry, and first serializer-deserializer (SERDES) circuitry connected to the first circuitry and the second circuitry; a second die including third circuitry, fourth circuitry and second SERDES circuitry connected to the third circuitry and the fourth circuitry; and an interconnect layer disposed between the first die and the second die, wherein the interconnect layer includes a first through silicon via (TSV) configured to be connected between the first SERDES circuitry and the second SERDES circuitry and to provide: a first signal path between the first circuitry and the third circuitry, a second signal path between the first circuitry and the fourth circuitry, a third signal path between the second circuitry and the third circuitry, and a fourth signal path between the second circuitry and the fourth circuitry.

In a second example, there is provided the processing chip component of the first example, wherein the first SERDES circuitry is configured to: perform serialization of a signal transmitted from the first circuitry with a signal transmitted from the second circuitry, and transmit a signal obtained based on the serialization to the second SERDES circuitry through the first TSV; and wherein the second SERDES circuitry is configured to obtain the signal to be transmitted to at least one of the third circuitry and the fourth circuitry based on deserialization of the signal transmitted through the first TSV.

In a third example, there is provided the processing chip component of the first or second example, wherein the interconnect layer further includes a second TSV connecting the first circuitry to the third circuitry; wherein the first circuitry is configured to: transmit a signal of a first type to the third circuitry through the second TSV in the interconnect layer, and transmit a signal of a second type to the first SERDES circuitry to transmit the signal of the second type to the third circuitry via the first TSV.

In a fourth example, there is provided the processing chip of the third example, wherein the second TSV provides a fifth signal path between the first circuitry and the third circuitry, and wherein the fifth signal path does not include the first SERDES circuitry and does not include the second SERDES circuitry.

In a fifth example, there is provided the processing chip component of the third or fourth examples, wherein the signal of the first type comprises a data signal to be inputted to the third circuitry, and wherein the signal of the second type comprises a control signal corresponding to the third circuitry.

In a sixth example, there is provided the processing chip component of any of the second to fifth examples, wherein the first SERDES circuitry comprises: a buffer for storing bits received from the first circuitry and the second circuitry, wherein each of the bits corresponds to at least one of the first signal path, the second signal path, the third signal path or the fourth signal path; and a controller configured to generate a sequence of bits to be included in a signal to be transmitted to the second die through the first TSV by performing serialization with respect to the bits stored in the buffer.

In a seventh example, there is provided the processing chip component of the sixth example, wherein the first SERDES circuitry is configured to: store the bits which are obtained from the first circuitry and the second circuitry in a preset time section, into the buffer; and perform the serialization of the bits stored in the buffer based on expiration of the preset time section.

In an eighth example, there is provided the processing chip component of any of the first to seventh examples, wherein the first circuitry comprises central processing unit (CPU) circuitry; and wherein the second circuitry comprises graphic processing unit (GPU) circuitry.

In a ninth example, there is provided the processing chip component of the eighth example, wherein the third circuitry comprises image signal processor (ISP) circuitry; and wherein the fourth circuitry comprises display controlling circuitry.

In a tenth example, there is provided the processing chip component of the ninth example, wherein the interconnect layer comprises: a second TSV connected to a second signal pin of the CPU circuitry, wherein the CPU circuitry includes a first signal pin connected to the first SERDES circuitry; and wherein the ISP circuitry comprises a third signal pin which is electrically connected to the second TSV.

In an eleventh example, there is provided the processing chip component of the tenth example, wherein the CPU circuitry is configured to: transmit a control signal to request data from the ISP circuitry, to the first SERDES circuitry through the first signal pin, and receive, through the second signal pin connected to the second TSV, the data corresponding to the control signal from the ISP circuitry.

In a twelfth example, there is provided the processing chip component of the eighth example, wherein the third circuitry comprises memory interface circuitry to communicate with a memory connected to the processing chip component; and wherein the fourth circuitry comprises neural processing unit (NPU) circuitry.

In a thirteenth example, there is provided the processing chip component of any of the first to twelfth examples, wherein the second SERDES circuitry is configured to: generate a signal to be transmitted to the first SERDES circuitry through the first TSV based on serialization of signals transmitted from the third circuitry and the fourth circuitry.

In a fourteenth example, there is provided the processing chip component of the thirteenth example, wherein the first circuitry comprises a central processing unit (CPU); and wherein the second SERDES circuitry is configured to: receive, from the third circuitry, a signal for notifying, to the first circuitry, at least one of a state of the third circuitry or an interruption associated with the third circuitry.

In a fifteenth example, there is provided the processing chip component of any of the first to fourteenth examples, wherein the second SERDES circuitry is configured to: obtain at least one bit corresponding to each of the first signal path, the second signal path, the third signal path and the fourth signal path based on a digit of each of a plurality of bits in a signal transmitted through the first TSV based on deserialization.

In a sixteenth example, there is provided the processing chip component of any of the first to fifteenth examples, wherein the first die is configured to comprise a circuit element having a size smaller than minimum size of circuit elements included in the second die.

In a seventeenth example, there is provided the processing chip component of any of the first to sixteenth examples, wherein the first die comprises circuitry produced by a process capable of implementing a circuit element based on a first minimum line width; wherein the second die comprises circuitry produced by a process capable of implementing a circuit element based on a second minimum line width; and wherein the second minimum line width is greater than the first minimum line width.

In an eighteenth example, there is provided the processing chip component of any of the first to seventeenth examples, wherein the first SERDES circuitry is configured to: transmit a signal that is obtained based on serialization and encoded based on bi-phase mark coding (BMC) scheme, to the second SERDES circuitry through the first TSV.

In a nineteenth example, there is provided the processing chip component of any of the first to eighteenth examples, wherein a power state of at least one of the first SERDES circuitry and the second SERDES circuitry is controlled independently of a power state of a CPU included in the processing chip component.

In a twentieth example, there is provided the processing chip component of any of the first to nineteenth examples, wherein the interconnect layer comprises an auxiliary TSV configured to be connected between the first SERDES circuitry and the second SERDES circuitry, and configured to provide: an auxiliary first signal path between the first circuitry and the third circuitry, an auxiliary second signal path between the first circuitry and the fourth circuitry, an auxiliary third signal path between the second circuitry and the third circuitry, and an auxiliary fourth signal path between the second circuitry and the fourth circuitry.

In a twenty-first example, there is provided the processing chip component of the twentieth example, wherein the first die comprises a first switching circuit; wherein the second die comprises a second switching circuit; and wherein the first switching circuit and the second switching circuit are configured to control a connection between the first SERDES circuitry and the second SERDES circuitry by switching the connection between the first TSV and the auxiliary TSV.

In a twenty-second example, there is provided the processing chip component of any of the first to twenty-first examples, wherein the interconnect layer comprises a plurality of TSVs; wherein the first SERDES circuitry comprises: first protocol circuitry configured to support a first communication protocol, second protocol circuitry configured to support a second communication protocol, and a first multiplexer switching circuit configured to connect the plurality of TSVs to the first protocol circuitry and second protocol circuitry; wherein the second SERDES circuitry comprises: third protocol circuitry configured to support the first communication protocol, fourth protocol circuitry configured to support the second communication protocol, and a second multiplexer switching circuit configured to connect the plurality of TSVs to the third protocol circuitry and fourth protocol circuitry; and wherein the first multiplexer switching circuit and the second multiplexer switching circuit are configured to: select a communication protocol, establish a connection between the first protocol circuitry and the third protocol circuitry via the plurality of TSVs in the case that the first communication protocol is selected, and establish a connection between the second protocol circuitry and the fourth protocol circuitry via the plurality of TSVs in the case that the second communication protocol is selected.

The device described above may be implemented with a hardware component, a software component, and/or a combination of the hardware component and the software component. For example, the device and the component described in the embodiments may be implemented by using one or more general purpose computers or special purpose computers, such as a processor, controller, arithmetic logic unit (ALU), digital signal processor, microcomputer, field programmable gate array (FPGA), programmable logic unit (PLU), microprocessor, or any other device capable of executing and responding to instructions. The processing device may perform an operating system (OS) and one or more software applications executed on the operating system. In addition, the processing device may access, store, manipulate, process, and generate data in response to the execution of the software. For convenience of understanding, there is a case that one processing device is described as being used, but a person who has ordinary knowledge in the relevant technical field may see that the processing device may include a plurality of processing elements and/or a plurality of types of processing elements. For example, the processing device may include a plurality of processors or one processor and one controller. In addition, another processing configuration, such as a parallel processor, is also possible.

The software may include a computer program, code, instruction, or a combination of one or more thereof, and may configure the processing device to operate as desired or may command the processing device independently or collectively. The software and/or data may be embodied in any type of machine, component, physical device, computer storage medium, or device, to be interpreted by the processing device or to provide commands or data to the processing device. The software may be distributed on network-connected computer systems and stored or executed in a distributed manner. The software and data may be stored in one or more computer-readable recording medium.

The method according to the embodiment may be implemented in the form of a program command that may be performed through various computer means and recorded on a computer-readable medium. In this case, the medium may continuously store a program executable by the computer or may temporarily store the program for execution or download. In addition, the medium may be various recording means or storage means in the form of a single or a combination of several hardware, but is not limited to a medium directly connected to a certain computer system, and may exist distributed on the network. Examples of media may include may be those configured to store program instructions, including a magnetic medium such as a hard disk, floppy disk, and magnetic tape, optical recording medium such as a CD-ROM and DVD, magneto-optical medium, such as a floptical disk, and ROM, RAM, flash memory, and the like. In addition, examples of other media may include recording media or storage media managed by app stores that distribute applications, sites that supply or distribute various software, servers, and the like.

As described above, although the embodiments have been described with limited examples and drawings, a person who has ordinary knowledge in the relevant technical field is capable of various modifications and transform from the above description. For example, even if the described technologies are performed in a different order from the described method, and/or the components of the described system, structure, device, circuit, and the like are coupled or combined in a different form from the described method, or replaced or substituted by other components or equivalents, appropriate a result may be achieved.

Therefore, other implementations, other embodiments, and those equivalent to the scope of the claims are in the scope of the claims described later.

## Claims

1. A processing chip component comprising:
a first die including first circuitry, second circuitry, and first serializer-deserializer (SERDES) circuitry connected to the first circuitry and the second circuitry;
a second die including third circuitry, fourth circuitry and second SERDES circuitry connected to the third circuitry and the fourth circuitry; and
an interconnect layer disposed between the first die and the second die,
wherein the interconnect layer includes a first through silicon via (TSV) configured to be connected between the first SERDES circuitry and the second SERDES circuitry and to provide:
a first signal path between the first circuitry and the third circuitry,
a second signal path between the first circuitry and the fourth circuitry,
a third signal path between the second circuitry and the third circuitry, and
a fourth signal path between the second circuitry and the fourth circuitry.

2. The processing chip component of claim 1, wherein the interconnect layer further includes a second TSV connecting the first circuitry to the third circuitry,
wherein the first circuitry is configured to:
transmit a signal of a first type to the third circuitry through the second TSV in the interconnect layer,
transmit a signal of a second type to the first SERDES circuitry to transmit the signal in the second type to the third circuitry,
wherein the first SERDES circuitry is configured to:
perform serialization of the signal of the second type with a signal transmitted from the second circuitry,
transmit a signal obtained based on the serialization to the second SERDES circuitry through the first TSV,
wherein the second SERDES circuitry is configured to obtain the signal of the second type to be transmitted to the third circuitry based on deserialization of the signal transmitted through the first TSV.

3. The processing chip component of claim 2, wherein the signal of the first type comprises a data signal to be inputted to the third circuitry ,
wherein the signal in the second type comprises a control signal corresponding to the third circuitry.

4. The processing chip component of claim 2, wherein the first SERDES circuitry comprises:
a buffer for storing bits received from the first circuitry and the second circuitry, wherein the bits are corresponding to each of the first signal path, the second signal path, the third signal path and the fourth signal path; and
a controller configured to generate a sequence of bits to be included in a signal to be transmitted to the second die through the first TSV by performing serialization with respect to the bits stored in the buffer.

5. The processing chip component of claim 4, wherein the first SERDES circuitry is configured to:
store the bits which are obtained from the first circuitry and the second circuitry in a preset time section, into the buffer;
perform the serialization of the bits stored in the buffer based on expiration of the preset time section.

6. The processing chip component of claim 1,
wherein the first circuitry is corresponding to a central processing unit (CPU) circuitry,
wherein the second circuitry is corresponding to a graphic processing unit (GPU) circuitry.

7. The processing chip component of claim 6,
wherein the third circuitry is corresponding to an image signal processor (ISP) circuitry,
wherein the fourth circuitry is corresponding to a display controlling circuitry, and
wherein the interconnect layer comprises:
a second TSV connected to a second signal pin of the CPU circuitry, wherein the CPU circuitry includes a first signal pin connected to the first SERDES circuitry,
wherein the ISP circuitry comprises a third signal pin which is electrically connected to the second TSV; and wherein the CPU circuitry is configured to:
transmit a control signal to request data from the ISP circuitry, to the first SERDES circuitry through the first signal pin,
receive, through the second signal pin connected to the second TSV, the data corresponding to the control signal from the ISP circuitry.

8. The processing chip component of claim 6,
wherein the third circuitry is corresponding to a memory interface circuitry to communicate with memory connected to the processing chip component,
wherein the fourth circuitry is corresponding to a neural processing unit (NPU) circuitry.

9. The processing chip component of any preceding claim, wherein the second SERDES circuitry is configured to:
generate a signal to be transmitted to the first SERDES circuitry through the first TSV based on serialization of signals transmitted from the third circuitry and the fourth circuitry.

10. The processing chip component of claim 9, wherein the second SERDES circuitry is configured to:
receive, from the third circuitry, the signal for notifying, to first circuitry that is a central processing unit (CPU), at least one of a state of the third circuitry or interruption associated with the third circuitry.

11. The processing chip component of any preceding claim, wherein the second SERDES circuitry is configured to:
obtain at least one bit corresponding to each of the first signal path, the second signal path, the third signal path and the fourth signal path based on digit of each of a plurality of bits in a signal transmitted through the first TSV based on deserialization.

12. The processing chip component of any preceding claim, wherein the first die is configured to comprise a circuit element having a size smaller than minimum size of circuit elements included in the second die.

13. The processing chip component of any preceding claim, wherein the first SERDES circuitry is configured to:
transmit the signal that is obtained based on the serialization and encoded based on bi-phase mark coding (BMC) scheme, to the second SERDES circuitry through the first TSV.

14. The processing chip component of any preceding claim, wherein the interconnect layer comprises an auxiliary TSV configured to be connected between the first SERDES circuitry and the second SERDES circuitry, and configured to provide:
an auxiliary first signal path between the first circuitry and the third circuitry,
an auxiliary second signal path between the first circuitry and the fourth circuitry,
an auxiliary third signal path between the second circuitry and the third circuitry, and
an auxiliary fourth signal path between the second circuitry and the fourth circuitry;
wherein the first die comprises a first switching circuit;
wherein the second die comprises a second switching circuit; and
wherein the first switching circuit and the second switching circuit are configured to control a connection between the first SERDES circuitry and the second SERDES circuitry by switching the connection between the first TSV and the auxiliary TSV.

15. The processing chip component of any preceding claim, wherein the interconnect layer comprises a plurality of TSVs;
wherein the first SERDES circuitry comprises:
first protocol circuitry configured to support a first communication protocol,
second protocol circuitry configured to support a second communication protocol, and
a first multiplexer switching circuit configured to connect the plurality of TSVs to the first protocol circuitry and second protocol circuitry;
wherein the second SERDES circuitry comprises:
third protocol circuitry configured to support the first communication protocol,
fourth protocol circuitry configured to support the second communication protocol, and
a second multiplexer switching circuit configured to connect the plurality of TSVs to the third protocol circuitry and fourth protocol circuitry; and
wherein the first multiplexer switching circuit and the second multiplexer switching circuit are configured to:
select a communication protocol,
establish a connection between the first protocol circuitry and the third protocol circuitry via the plurality of TSVs in the case that the first communication protocol is selected, and
establish a connection between the second protocol circuitry and the fourth protocol circuitry via the plurality of TSVs in the case that the second communication protocol is selected.
